(19) Europäisches Patentamt
European Patent Office
Office européen des brevets

(11) EP 2 262 116 B1

(12) # FASCICULE DE BREVET EUROPEEN

(45) Date de publication et mention de la délivrance du brevet:
**28.12.2011 Bulletin 2011/52**

(51) Int Cl.:
***H03M 13/41*** *(2006.01)*

(21) Numéro de dépôt: **10164997.8**

(22) Date de dépôt: **04.06.2010**

(54) **Décodeur Viterbi avec deux memoires adapté aux signaux GNSS**

Viterbi Dekoder mit zwei Speichern angepasst für GNSS Signale

Viterbi decoder with two memories adapted to GNSS signals

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **09.06.2009 FR 0902782**

(43) Date de publication de la demande:
**15.12.2010 Bulletin 2010/50**

(73) Titulaire: **Thales**
**92200 Neuilly Sur Seine (FR)**

(72) Inventeurs:
- **Dumas, Pierre-Yves**
  **07500 Guilherand-Granges (FR)**
- **Clauzel, Yves**
  **26200 Montelimar (FR)**
- **Perre, Jean-Michel**
  **07130 St Peray (FR)**

(74) Mandataire: **Henriot, Marie-Pierre et al**
**Marks & Clerk France**
**Conseils en Propriété Industrielle**
**Immeuble " Visium "**
**22, avenue Aristide Briand**
**94117 Arcueil Cedex (FR)**

(56) Documents cités:
**DE-U1- 20 109 857 US-A- 5 887 036**
**US-A1- 2006 195 773**

- **RATTAN S S ET AL: "DESIGN OF MICROPROCESSOR BASED VITERBI DECODER" STUDENTS JOURNAL OF THE INSTITUTION OF ELECTRONICS ANDTELECOMMUNICATION ENGINEERS, NEW DEHLI, IN, vol. 34, no. 3/04, 1 juillet 1993 (1993-07-01), pages 183-194, XP002037816 ISSN: 0970-1664**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 2 262 116 B1

## Description

Le domaine de l'invention est celui de la réception d'un signal numérique codé selon un codage de Viterbi ; il s'agit plus particulièrement du décodage de ce signal reçu, selon un décodage de Viterbi à treillis.

Très utilisé dans le domaine des communications de données, le codage des données transmises permet d'améliorer grandement la résistance aux erreurs de transmissions numériques en rajoutant des symboles de redondance astucieusement calculés. Ces symboles de redondance permettent au récepteur de détecter et de corriger des erreurs sans qu'il soit nécessaire de demander à l'émetteur de retransmettre les données. C'est particulièrement intéressant lorsque les retransmissions sont coûteuses voire impossibles, comme par exemple dans le domaine des transmissions radio et plus spécifiquement lorsque ces transmissions sont bruitées comme c'est le cas pour les transmissions par satellites. Il existe plusieurs types de codages correcteurs d'erreurs parmi lesquels le codage par blocs et le codage convolutif ainsi désigné car fondé sur la convolution des données d'entrée avec les réponses impulsionnelles du codeur. Le codage de Viterbi est un codage convolutif.

Les bits à émettre sont introduits dans un registre à décalage de longueur lc-1 pour être codés comme illustré figure 1, lc étant désignée longueur de contrainte. On parle aussi de registre à lc-1 étages.

Un codeur est défini par des polynômes et il comprend K registres de mémoire, K étant le nombre de lignes à retard (constituant le registre à décalage) nécessaires pour implémenter les polynômes. On a lc=K.

Un codeur de Viterbi dont l'implémentation est représentée figure 2 est défini par les deux polynômes G1 (x), G2(x) suivants :

$$G1(x) = x^6+x^5+x^4+x^3+1$$

$$G2(x) = x^6+x^4+x^3+x^2+1$$

Un codeur convolutif est souvent considéré comme une machine à états finis. Chaque état correspond à une valeur du registre du codeur. A partir d'un bit d'entrée (1 ou 0), en fonction de l'état du registre d'entrée du codeur, on obtient (par décalage des bits du registre d'entrée puis en prenant le bit d'entrée pour le bit manquant), deux états autorisés en sortie du codeur, soit deux transitions possibles, les autres étant interdites. Et ainsi de suite. Ces transitions d'état sont représentées par des arcs sur un diagramme désigné treillis. Les états du codeur sont représentés par les noeuds du treillis. On a représenté figure 3 un exemple de maille élémentaire d'un treillis pour lc = 3. Une maille élémentaire aussi désignée treillis élémentaire illustre pour tous les états de départ les transitions (ou arcs) autorisées entre un état de départ et un état d'arrivée. Les traits pleins correspondent à l'émission d'un « 1 », les traits en pointillé correspondent à l'émission d'un « 0 » ; cette convention est conservée par la suite.

Un treillis permet aussi de représenter le codage : ceci est obtenu en étiquetant les arcs du treillis en fonction de ce codage. On a représenté figure 5 un exemple de treillis correspondant à un codage dont l'implémentation est représentée figure 4 et qui est défini par les polynômes :

$$G1(x) = x^2+x+1$$

$$G2(x) = x^2+1$$

Les étiquettes sur les arcs de la maille représentent la paire de symboles (G1, G2) émis en sortie du codeur ; ils ont été obtenus de la façon suivante, G1 et G2 étant calculés modulo 2 :

- partant de l'état 00, en introduisant le bit 1, on obtient G1 (1) = 1 et G2(1) = 1
- partant de l'état 00, en introduisant le bit 0, on obtient G1 (0) = 0 et G2(0) = 0
- partant de l'état 01, en introduisant le bit 1, on obtient G1 (1) = 0 et G2(1) = 0
- partant de l'état 01, en introduisant le bit 0, on obtient G1 (0) = 1 et G2(0) = 1
- partant de l'état 10, en introduisant le bit 1, on obtient G1 (1) = 0 et G2(1) = 1
- partant de l'état 10, en introduisant le bit 0, on obtient G1 (0) = 1 et G2(0) = 0
- partant de l'état 11, en introduisant le bit 1, on obtient G1 (1) = 1 et G2(1) = 0
- partant de l'état 11, en introduisant le bit 0, on obtient G1 (0) = 0 et G2(0) = 1.

Partant d'une ligne à retard initialisée à « 0 », on émet la séquence 1001 : le chemin représenté figure 6 se traduit par l'émission de la séquence de symboles, 11 10 11 11 générés par le codage de l'exemple précédent.

Chaque chemin du treillis correspond à une séquence valide de bits codés; et inversement, n'importe quelle séquence valide peut être représentée par un chemin.

Côté réception, les données doivent donc être décodées. Lorsqu'une erreur survient générée par exemple par le canal de transmission (on reçoit 11 00 11 11 au lieu de 11 10 11 11), le récepteur recevra un symbole correspondant à une transition interdite, qui n'est pas sur un chemin possible. La tâche du décodeur est alors de trouver un chemin qui soit le plus proche possible du chemin de la séquence de bits envoyés.

Si le codeur est d'implémentation relativement triviale, le décodeur (implanté dans le récepteur) nécessite plus de calculs.

Le décodeur Viterbi utilise traditionnellement l'algorithme du treillis qui permet une détection optimale en terme de performance et de charge de calcul des symboles d'erreur. De nombreuses implémentations matérielles ou logicielles de ce décodeur proposant ou non un paramétrage manuel sont disponibles.

Les données reçues par le récepteur sont en général des données analogiques bruitées. Par exemple le bit 1 émis devient 0,8 à la réception. Un codage peut alors être introduit à la réception, pour prendre en considération le fait que certaines données reçues sont plus certaines que d'autres : selon ce codage dit à décision pondérée ou « soft décision » en anglais, chaque donnée reçue est codée sur n bits (on a en général n=3 qui correspond à une pondération variant entre 0 et 7). On parle alors de décodeur de Viterbi à décision pondérée.

Un codage à décision ferme ou binaire, ou « hard decision » en anglais désigne un codage sans cette pondération c'est-à-dire pondérée avec 0 bit (n=1) : il s'agit finalement d'un cas particulier de codage à décision pondérée.

L'utilisation du mécanisme de « soft decision » permet d'améliorer les performances de diminution du taux d'erreur binaire (TEB).

Les différentes implémentations de cet algorithme permettent soit de privilégier la rapidité de l'algorithme (adaptée à un débit élevé de données) en parallélisant les ressources, soit au contraire d'optimiser l'utilisation des ressources (taille de silicium pour implémentation matérielle, taux de charge pour implémentation logicielle), au détriment du débit. Dans le cas des récepteurs GNSS le débit reste faible (quelques centaines de Hertz au maximum) et on s'intéresse donc à une optimisation des ressources.

Des exemples de décodeurs de Viterbi à deux mémoires sont décrits dans les documents US 2006/195773, DE 201 09 857, US 5 887 036 et « Design of microprocessor based Viterbi decoder » Rattan S S et al, Students journal of the institution of electronics and telecommunications engineers, New-Dehli, In.

L'invention propose une implémentation matérielle particulière d'un décodeur de Viterbi à décision pondérée et à treillis, optimisant les ressources matérielles nécessaires ; cette implémentation est notamment adaptée au besoin GNSS. Elle est rendue possible par la mise en oeuvre d'un procédé de décodage spécifique ; l'invention a également pour objet, ce procédé.

Plus précisément, l'invention a pour objet un récepteur d'un signal numérique équipé d'un décodeur Viterbi à treillis à N états, et à décision pondérée, le treillis étant établi à partir d'un treillis élémentaire comportant N états de départ et N états d'arrivée, chaque état de départ étant relié à deux états d'arrivés par des arcs étiquetés, le signal reçu comportant une suite de symboles. Il est principalement caractérisé en ce qu'il comprend un circuit logique programmable qui comporte :

- une mémoire source A et une mémoire destination B comprenant chacune N lignes et M+L colonnes respectivement attribuées à M champs fixes de description du treillis, et à L champs variables, les champs fixes comportant au moins deux champs d'adresse de destination, un par état d'arrivée et deux champs d'étiquettes des arcs correspondants, les champs variables comportant au moins un champ de distance cumulée en fonction des étiquettes du treillis élémentaire et des symboles reçus, et un champ de séquence des S derniers bits décodés,
- un opérateur apte à calculer les champs variables d'une mémoire en fonction des champs fixes de ladite mémoire, des symboles reçus et des champs variables de l'autre mémoire et à inverser le rôle des mémoires source et destination.

Selon une autre caractéristique de l'invention, N étant égal à $2^{lc}$, lc étant la longueur de contrainte du codeur, les adresses de destination sont définies sur lc bits.

De préférence, M=4 et L=2 ou 3.

La décision pondérée étant codée sur n bits, les étiquettes sont alors définies sur n bits.

Selon une caractéristique de l'invention, les champs variables comportent en outre un champ indiquant pour chaque ligne de la mémoire si la distance cumulée a déjà été calculée pour le symbole reçu. Ce champ indicateur est par exemple défini sur un bit.

Ce récepteur est typiquement un récepteur GNSS.

L'invention a aussi pour objet un procédé de réception d'un signal numérique au moyen d'un récepteur tel que précédemment décrit, comportant une étape de décodage qui comprend une étape de traitement de chaque symbole reçu qui comporte pour chaque ligne de la mémoire source les sous-étapes suivantes pour chacune des deux adresses de cette ligne :

- Calcul par l'opérateur de la distance entre le symbole reçu et l'étiquette du champ étiquette associé à cette adresse,
- Calcul par l'opérateur de la distance cumulée de la mémoire destination à cette adresse à partir de ladite distance et de la distance cumulée de ladite ligne de la mémoire source, cette distance dite dernière distance étant associée à une séquence décodée,

caractérisé en ce que cette étape de traitement de symboles comprend en outre la sous-étape suivante :

si une distance cumulée dite distance cumulée précédente a déjà été calculée à cette adresse, choix par l'opérateur pour cette adresse de la plus petite distance cumulée entre cette distance cumulée précédente et la dernière distance cumulée, et mise à jour de la séquence décodée par la séquence associée à la distance cumulée choisie.

Selon une caractéristique de l'invention, à la fin de l'étape de traitement du symbole reçu, le rôle des mémoires source et destination est inversé.

A la fin de l'étape de traitement du symbole reçu, la distance cumulée de chaque ligne de la mémoire destination est avantageusement normalisée pour éviter un débordement du champ distance cumulée. Cette normalisation consiste par exemple à soustraire à toutes les distances cumulée la plus petite distance cumulée.

Selon une caractéristique de l'invention, la valeur de l'indicateur du champ indicateur s'inverse lorsque la distance cumulée a déjà été calculée et à la fin de l'étape de traitement du symbole reçu, cet indicateur est réinitialisé pour chaque ligne de la mémoire.

Ce procédé permet de définir une partie de l'architecture d'un circuit logique programmable (ASIC ou FPGA) dédiée au décodage des messages émis par les satellites d'un système de positionnement GNSS (Galileo, EGNOS, GPS, etc.). Pour réduire le taux d'erreur de bits dû à la transmission, ces messages sont codés au niveau du satellite suivant l'algorithme de Viterbi. Le déport du décodage à l'intérieur d'une puce de traitement de signal existant permet de libérer des ressources software dans les processeurs de traitement des récepteurs GNSS.

Ce procédé permet ainsi d'optimiser la taille et donc le volume et la consommation du composant ce qui peut se faire dans la mesure où l'on est peu contraint par la problématique du débit de données GNSS.

D'autres caractéristiques et avantages de l'invention apparaîtront à la lecture de la description détaillée qui suit, faite à titre d'exemple non limitatif et en référence aux dessins annexés dans lesquels :

la figure 1 déjà décrite représente schématiquement un registre à décalage à K-1 étages,
la figure 2 déjà décrite représente schématiquement l'implémentation d'un codeur Viterbi,
la figure 3 déjà décrite représente schématiquement une maille élémentaire d'un treillis pour K = 3,
la figure 4 déjà décrite représente schématiquement l'implémentation d'un exemple de codeur,
la figure 5 déjà décrite représente schématiquement le treillis élémentaire (ou maille élémentaire) du codeur de la figure 4,
la figure 6 déjà décrite représente schématiquement le chemin pour une séquence émise égale à 1001 à partir du treillis de la figure 4,
les figures 7a à 7c représentent schématiquement un exemple de construction selon l'invention, du treillis associé au décodage selon la maille élémentaire de la figure 5, de la séquence de symboles reçus 11 00 11 11,
les figures 8a à 8c représentent schématiquement l'initialisation des mémoires A et B (fig 8a), leur mise à jour induite par la réception de la première paire de symboles (11) de l'exemple considéré (fig 8b, 8c), selon l'invention,
les figures 9a à 9c représentent schématiquement, la mise à jour des mémoires A et B induite par la réception de la 2è paire de symboles (00) de l'exemple considéré, selon l'invention,
les figures 10a à 10f représentent schématiquement, la mise à jour des mémoires A et B induite par la réception de la 3è paire de symboles (11) de l'exemple considéré, selon l'invention,
les figures 11 a à 11f représentent schématiquement, la mise à jour des mémoires A et B induite par la réception de la 4è paire de symboles (11) de l'exemple considéré, selon l'invention,
la figure 12 représente schématiquement l'implémentation selon l'invention du procédé de décodage présenté.

D'une figure à l'autre, les mêmes éléments sont repérés par les mêmes références.

On va tout d'abord dérouler le procédé de décodage Viterbi sur lequel est basée l'implémentation matérielle du décodeur selon l'invention. Ce déroulement décrit en relation avec les figures 7a à 7c, est réalisé sur le même exemple que précédemment : la séquence reçue à décoder est 11 00 11 11. Les symboles sont reçus par paires.

Le premier symbole reçu est la paire 11. Sachant qu'on part de l'état 00 (état d'initialisation avec i=0), les deux états possibles suivants sont 00 ou 10. En reportant sur chaque arc les étiquettes des arcs du treillis élémentaire, on a pour la colonne i=1:

- une distance (indiquée entre parenthèses à côté des étiquettes) égale à 2 en comparant la séquence reçue 11 à 00, une distance cumulée (indiquée entre parenthèses sur chaque noeud) aussi égale à 2, le bit décodé correspondant (souligné à côté de chaque noeud) étant 0,
- une distance de 0 en comparant la séquence reçue 11 à 11, une distance cumulée aussi égale à 0, le bit correspondant étant 1.

Le deuxième symbole reçu est la paire 00. En partant d'un des deux états possibles à savoir l'état 00, on a pour la colonne i=2:

- une distance égale à 0 en comparant la séquence reçue 00 à 00, une distance cumulée qui reste égale à 2, le bit correspondant étant 0, la séquence de bits décodés (soulignée à côté de chaque noeud) étant 00,
- une distance de 2 en comparant la séquence 00 à 11, une distance cumulée égale à 4, le bit correspondant étant 1, la séquence de bits décodés étant 01.

En partant de l'autre état possible à savoir l'état 10, on a toujours pour i=2 :

- une distance égale à 1 en comparant la séquence 00 à 01, une distance cumulée égale à 1, le bit correspondant étant 1, la séquence de bits décodés étant 11,
- une distance de 1 en comparant la séquence 00 à 10, une distance cumulée égale à 1, le bit correspondant étant 0, la séquence de bits décodés étant 10.

Le troisième symbole reçu est la paire 11. En partant d'un des quatre états possibles à savoir l'état 00, on a pour la colonne i=3:

- une distance égale à 2 en comparant la séquence reçue 11 à 00, une distance cumulée égale à 4, le bit correspondant étant 0, la séquence de bits décodés étant 000,
- une distance de 0 en comparant la séquence 11 à 11, une distance cumulée égale à 2, le bit correspondant étant 1, la séquence de bits décodés étant 001.

En partant d'un autre état possible à savoir l'état 01, on a pour la colonne i=3:

- une distance égale à 0 en comparant la séquence 11 à 11, une distance cumulée égale à 1, le bit correspondant étant 0, la séquence de bits décodés étant 100,
- une distance de 2 en comparant la séquence 11 à 00, une distance cumulée égale à 3, le bit correspondant étant 1, la séquence de bits décodés étant 101.

En partant d'un autre état possible à savoir l'état 10, on a pour la colonne i=3:

- une distance égale à 1 en comparant la séquence 11 à 01, une distance cumulée égale à 5, le bit correspondant étant 1, la séquence de bits décodés étant 011,
- une distance de 1 en comparant la séquence 11 à 10, une distance cumulée égale à 5, le bit correspondant étant 0, la séquence de bits décodés étant 010.

En partant du quatrième autre état possible 11, on a pour la colonne i=3:

- une distance égale à 1 en comparant la séquence 11 à 10, une distance cumulée égale à 2, le bit correspondant étant 1, la séquence de bits décodés étant 111,
- une distance de 1 en comparant la séquence 11 à 01, une distance cumulée égale à 2, le bit correspondant étant 0, la séquence de bits décodés étant 110.

A partir de cette quatrième colonne de noeuds (i=3), chaque état est atteint par deux chemins. Par exemple l'état 00 peut être atteint à partir :

- du chemin dont les états sont 00, 00, 00, 00, avec une distance cumulée égale à 4, la séquence décodée étant 000, ou
- du chemin dont les états sont 00, 10, 01, 00 avec une distance cumulée égale à 1, la séquence décodée étant 100.

On ne conserve que le chemin dont la distance cumulée est la plus petite (en fait inférieure ou égale mais selon une alternative on pourrait choisir la distance strictement inférieure); et la distance cumulée attribuée à cet état est alors cette plus petite distance.

De la sorte on ne conserve pour cette colonne i=3, pour :

- l'état 00, que la séquence 100 associée à la distance cumulée 1 (au lieu de 000 associée à la distance cumulée 4),
- l'état 01, que la séquence 110 associée à la distance cumulée 2 (au lieu de 010 associée à la distance cumulée 5),
- l'état 10, que la séquence 001 associée à la distance cumulée 2 (au lieu de 101 associée à la distance cumulée 3),
- l'état 11, que la séquence 111 associée à la distance cumulée 2 (au lieu de 011 associée à la distance cumulée 5).

Le procédé est ensuite déroulé entre les colonnes i=3 et i=4 et décrit en relation avec les figures 7b, 7c. On ne conserve pour :

- l'état 00, que la séquence 1100 associée à la distance cumulée 2 (au lieu de 1000 associée à la distance cumulée 3),
- l'état 01, que la séquence 1110 associée à la distance cumulée 3,
- l'état 10, que la séquence 1001 associée à la distance cumulée 1 (au lieu de 1101 associée à la distance cumulée 4),
- l'état 11, que la séquence 0011 associée à la distance cumulée 3.

On peut alors retrouver la séquence initialement émise en partant de l'état ayant la plus petite distance cumulée, soit 1 dans notre exemple avec la séquence décodée 1001 (qui a été entourée figure 7c), qui est bien l'inverse de la séquence initialement émise : le décodeur a donc retrouvé la bonne séquence malgré l'erreur qui s'était introduite sur les symboles reçus.

Le décodeur Viterbi considéré ici est conçu pour une implémentation matérielle sur un circuit logique programmable de type ASIC ou FPGA, qui permet d'optimiser les ressources matérielles utilisées (RAM, nombre de bascules...).

A la réception, comme on vient de le voir sur notre exemple, on génère un treillis à partir de la maille élémentaire en inscrivant :

- sur les arcs, la distance entre les symboles reçus et les étiquettes associés à l'arc,
- sur chaque noeud, la distance cumulée depuis le début.

L'état de décodage peut être représenté à tout moment par la dernière colonne du treillis avec les $2^{K-1}$ chemins survivants.

Ce procédé est implémenté de la manière suivante. Le décodeur selon l'invention comprend deux mémoires qui ont la même organisation, l'une étant désignée mémoire source, l'autre mémoire destination et un opérateur qui travaille en bascule sur ces deux mémoires. La taille de ces mémoires est dimensionnée d'après la longueur de contrainte lc (correspondant à la « mémoire » du décodeur ) : elles comptent $2^{lc}$ mots ou lignes. Chaque mot doit contenir les champs suivants

Adresse destination1 définie sur lc bits,
Adresse destination2 définie sur lc bits,
Distance adresse1 (ou métrique1) définie sur n bits,
Distance adresse2 (ou métrique2) définie sur n bits,
Distance cumulée (ou Distance totale) définie sur m bits, avec $n<m\leq S+n$,
Séquence décodée définie sur S bits,
Indicateur d'état défini sur 1 bit,

Où :

n est le nombre de bits utilisés pour coder la décision pondérée,
S la profondeur de traceback maximale souhaitée.

Selon l'invention, la Distance cumulée est la distance cumulée sur le chemin choisi qui, des deux chemins possibles est celui qui a la plus petite distance cumulée ; elle est calculée à partir de la distance euclidienne entre la paire de symboles reçue et l'étiquette associée à l'arc. Soient x le premier symbole reçu et y le second, et x0 et y0 les valeurs idéales ; la distance euclidienne M est alors de la forme :

$$M=(x-x0)^2 + (y-y0)^2$$

Cette distance est généralement codée sur 3 bits comme indiqué dans le préambule.

La Séquence décodée est la concaténation de l'ensemble des bits décodés correspondants aux symboles constituant le chemin choisi, le nombre de ces bits étant désigné profondeur de « traceback »,

l'Indicateur d'état (aussi désigné Flag dans la suite) indique si cette ligne de la mémoire a déjà été traitée, auquel cas on ne réécrit « Distance cumulée » et « Séquence décodée » que si on trouve un chemin ayant une plus petite distance cumulée.

Ces trois champs qui varient au fur et à mesure de l'arrivée des symboles, sont mis à jour à partir de la maille élémentaire du treillis c'est-à-dire à partir des champs prédéfinis suivants :

- les adresses dans la mémoire de destination (qui est une image de cette maille élémentaire) des deux états suivants autorisés, désignées adresse destination1, adresse destination2,
- les deux étiquettes des arcs correspondant à ces transitions autorisées, désignées distance adresse1 (ou métrique1) et distance adresse2 (ou métrique2).

Les quatre premiers champs sont des champs fixes c'est-à-dire préalablement définis à partir de la maille élémentaire du treillis, qui dépend du codage ; les trois derniers champs sont des champs qui varient au fur et à mesure que le traitement des symboles reçus se déroule.

Le traitement est réalisé au moyen de l'implémentation représentée figure 12 qui comprend une mémoire source A 10, une mémoire destination B 20, interchangeables et un opérateur 30 relié à ces mémoires. Selon un mode d'exploitation privilégié, cette implémentation ne comprend que ces 2 mémoires 10, 20 et cet opérateur 30.

De manière classique les symboles reçus proviennent d'une mémoire de symboles 40, les bits décodés sont stockés dans une mémoire de bits décodés 50.

Le traitement consiste à analyser l'ensemble des symboles reçus de la mémoire 40 en temps réel ou en temps différé et, pour chaque symbole à parcourir la mémoire source de la ligne 0 jusqu'à la ligne $2^{lc-1}$ comme illustré figures 8a à 8c.

Pour chaque adresse de la mémoire source 10 (représentant un état possible de l'encodeur), sont disponibles deux adresses de la mémoire destination 20 représentant les deux états suivants possibles et les étiquettes associées à ces transitions.

Dans la mémoire destination, l'opérateur 30 met à jour :

- la distance cumulée en fonction des étiquettes des arcs de la maille élémentaire et des symboles reçus associés aux transitions,
- le chemin parcouru aussi désignée séquence décodée, qui est constitué de la concaténation des symboles correspondants à l'ensemble des transitions parcourues depuis le début du décodage : il s'agit d'une séquence de bits décodés (une paire de symboles décodés permettant de trouver le bit émis). Ce chemin est rempli par le haut, en décalant les bits décodés déjà présents vers les poids faibles. Un multiplexeur permet de choisir à partir de quelle position de cette séquence les bits décodés seront évacués vers la sortie, c'est-à-dire vers la mémoire « résultat c'est-à-dire la mémoire des bits décodés 50. Cette position correspond à la profondeur du chemin inverse aussi désignée profondeur de « traceback ».

- L'indicateur d'état (ou Flag) dont la valeur s'inverse à chaque nouveau symbole et qui a pour rôle de signifier que cette ligne de la mémoire de destination a été mise à jour. Cela est utile car chaque destination est traitée deux fois et on ne doit pas écrire un chemin moins bon que le chemin éventuellement déjà présent dans cette case. Ceci permet de « couper la branche » la moins bonne des deux. Cette fonction peut être assurée par un autre moyen non codé dans la mémoire mais qui serait un état interne à l'opérateur.

Une fois épuisées les lignes (ou mots) de la mémoire source 10, l'opérateur 30 évacue le bit calculé vers la mémoire de bits décodés 50, recadre les distances cumulées pour éviter un débordement du champ « distance cumulée », réinitialise les indicateurs, inverse le rôle des mémoires et passe à la paire de symboles suivante jusqu'à concurrence du nombre de symboles indiqués par une unité de contrôle et d'initialisation 60 ou bien tant que des symboles arrivent en temps réel.

Selon une variante privilégiée de l'invention, après avoir traité un nouveau symbole, l'opérateur 30 détermine la distance minimale parmi toutes celles trouvées en traitant un symbole et la soustrait à toutes les distances calculées, ceci de façon à éviter que les distances débordent. On « rabote » en quelque sorte la distance cumulée.

Lors du lancement du procédé de décodage, l'opérateur 30 est initialisé sur ordre de l'unité de contrôle et d'initialisation 60, à l'aide des paramètres suivants :

- nombre de symboles à traiter (pour un traitement par bloc) ou choix du mode temps réel,
- type de traitement (premier bloc, bloc intermédiaire ou dernier bloc).

Les mémoires 10, 20 sont initialisées par l'unité de contrôle et d'initialisation 60 avec les étiquettes des arcs associées à chaque noeud du treillis, dérivées de la maille élémentaire, c'est-à-dire des valeurs des polynômes G1 et G2 à utiliser.

Plus précisément, les champs suivants de chacune des 2 mémoires sont initialisés de la façon suivante :

Adresse destination1 (ou adresse 1) : par les valeurs dérivées des polynômes G1 et G2
Adresse destination2 (ou adresse 2): par les valeurs dérivées des polynômes G1 et G2
Distance add1 (ou métrique 1): par les étiquettes associées aux arcs du treillis
Distance add2 (ou métrique 2) : par les étiquettes associées aux arcs du treillis
Distance cumulée : à 0
Séquence décodée : à 0
Indicateur d'état (ou « flag ») : à 0

Ceci est illustré figure 8a dans laquelle les lignes correspondant aux adresses de la mémoire sont numérotées suivant la convention numérique de 0 à 3, 0 étant associé à l'état 00, 1 à l'état 01, 2 à l'état 10 et 3 à l'état 11.

On illustre en relation avec les figures 8b à 8c, le déroulement du procédé sur ces deux mémoires en l'appliquant à notre exemple. On utilise comme distance, la distance de Hamming qui est égale au nombre de bits différents (soit 0, 1 ou 2 pour un état à 2 bits) et qui s'applique à un décodeur à décision ferme (« hard décision »).

Le traitement du premier symbole reçu est le plus simple car l'état de départ étant connu, il limite les hypothèses.

On considère tout d'abord la réception du premier symbole, soit la paire 11.

« Réception du 1 er symbole 11 ; traitement de la ligne 0 » :

Dans ce cadre-là on traite d'abord les deux adresses de la ligne 0 (figure 8b) : étapes 1 à 5 pour l'adresse 1, étapes 6 à 11 pour l'adresse 2.

1. On calcule la distance totale correspondant à l'adresse 1 de la ligne 0 de la mémoire source:
2. Distance totale (B,adresse1(A,0)) = Distance totale (A,0) + abs{symbole reçu-metrique1 (A,0)}
Soit: Distance totale (B,0)) = 0 + abs({ 1;1}-{0;0}) =2
3. On vérifie la valeur du flag à l'adresse de la mémoire de destination pour s'assurer qu'elle n'a pas déjà été écrite durant ce cycle
Flag(B,0)=0 : pas encore écrite:
4. On change la valeur du flag pour dire que l'adresse a déjà été mise à jour : Flag(B,0)=1. On met à jour la distance totale dans la mémoire destination : Distance totale (B,0)) = 2
5. On met à jour la séquence des bits décodés de la mémoire destination avec la valeur correspondante: Symboles(B,0)=Symboles(A,0) décalé à gauche+k (k=0 pour adresse1 car il s'agit du bit 0,k=1pour adresse2 car il s'agit du bit 1, convention que l'on conservera pour la suite).
6. On calcule la distance totale correspondant à l'adresse 2 de la ligne 0 de la mémoire source:
7. Distance totale (B,adresse2(A,0)) = Distance totale (A,0) + abs{symbole reçu-metrique2(A,0)}
Soit: Distance totale (B,2)) = 0 + abs({ 1;1}-{1;1}) =0
8. On vérifie la valeur du flag à l'adresse de la mémoire de destination pour s'assurer qu'elle n'a pas déjà été écrite durant ce cycle
Flag(B,2)=0 : pas encore écrite:
10. On change la valeur du flag pour dire que l'adresse a déjà été mise à jour : Flag(B,2)=1. On met à jour la distance totale dans la mémoire destination : Distance totale (B,2)) = 0.

11.On met à jour la séquence des bits décodés de la mémoire destination avec la valeur correspondante: Symboles(B,2)=Symboles(A,0) décalé à gauche +k.

Comme il s'agit du premier symbole reçu et que l'état initial du décodeur est 0 (par hypothèse) on ne traite pas les lignes suivantes (on part d'un état unique connu). L'étape suivante est :

« Fin de traitement du 1 er symbole reçu 11 » (figure 8c).

1. On normalise les distances de manière à éviter un débordement : on retire à toutes les distances de la mémoire destination la valeur de la distance la plus faible (0).
2. On inverse le rôle des mémoires source et destination.
3. On remet à 0 tous les flags.

On considère alors le traitement du deuxième symbole reçu soit la paire 00. Dans ce cadre-là on traite d'abord la ligne 0 puis la ligne 2.

« Réception du 2è symbole 00 ; traitement de la ligne 0 » :

On traite pour la ligne 0 ses deux adresses (figure 9a) : étapes 1 à 5 pour l'adresse 1, étapes 6 à 11 pour l'adresse 2.

1. On calcule la distance totale correspondant à l'adresse 1 de la ligne 0 de la mémoire source:
2. Distance totale (A,adresse1(B,0)) = Distance totale (B,0) + abs{symbole reçu-metrique1 (B,0)}
Soit: Distance totale (A,0)) = 2+ abs({ 0;0}-{0;0}) =2
3. On vérifie la valeur du flag à l'adresse de la mémoire de destination pour s'assurer qu'elle n'a pas déjà été écrite durant ce cycle
Flag(A,0)=0 : pas encore écrite:
4. On change la valeur du flag pour dire que l'adresse a déjà été mise à jour : Flag(A,0)=1. On met à jour la distance totale dans la mémoire destination : Distance totale (A,0)) = 2
5. On met à jour la séquence des bits décodés de la mémoire destination avec la valeur correspondante: Symboles(A,0)=Symboles(B,0) décalé à gauche +k.
6. On calcule la distance totale correspondant à l'adresse 2 de la ligne 0 de la mémoire source:
7. Distance totale (A,adresse2(B,0)) = Distance totale (B,0) + abs{symbole reçu-metrique2(B,0)}
Soit: Distance totale (A,2)) = 2 + abs({ 0;0}-{1;1}) =4
8. On vérifie la valeur du flag à l'adresse de la mémoire de destination pour s'assurer qu'elle n'a pas déjà été écrite durant ce cycle
Flag(A,2)=0 : pas encore écrite:
9. On change la valeur du flag pour dire que l'adresse a déjà été mise à jour : Flag(A,2)=1. On met à jour la distance totale dans la mémoire destination : Distance totale (A,2)) =4.
10. On met à jour la séquence des bits décodés de la mémoire destination avec la valeur correspondante: Symboles(A,2)=Symboles(B,0) décalé à gauche +k.

On traite pour la ligne 2 ses deux adresses (figure 9b) : étapes 1 à 5 pour l'adresse 1, étapes 6 à 11 pour l'adresse 2.

« Réception du 2è symbole 00 ; traitement de la ligne 2 » :

1. On calcule la distance totale correspondant à l'adresse 1 de la ligne 2 de la mémoire source:
2. Distance totale (A,adresse1(B,2)) = Distance totale (B,2) + abs{symbole reçu-metrique1 (B,2)}
Soit: Distance totale (A,1)) = 0+ abs({ 0;0}-{1;0}) =1
3. On vérifie la valeur du flag à l'adresse de la mémoire de destination pour s'assurer qu'elle n'a pas déjà été écrite durant ce cycle
Flag(A,1)=0 : pas encore écrite:
4. On change la valeur du flag pour dire que l'adresse a déjà été mise à jour : Flag(A,1)=1. On met à jour la distance totale dans la mémoire destination : Distance totale (A,1)) =1.
5. On met à jour la séquence des bits décodés de la mémoire destination avec la valeur correspondante: Symboles(A,1)=Symboles(B,2) décalé à gauche +k.
6. On calcule la distance totale correspondant à l'adresse 2 de la ligne 2 de la mémoire source:
7. Distance totale (A,adresse2(B,2)) = Distance totale (B,2) + abs{symbole reçu-metrique2(B,2)}
Soit: Distance totale (A,3)) = 0 + abs({ 0;0}-{0;1}) =1
8. On vérifie la valeur du flag à l'adresse de la mémoire de destination pour s'assurer qu'elle n'a pas déjà été écrite durant ce cycle
Flag(A,3)=0 : pas encore écrite:
9. On change la valeur du flag pour dire que l'adresse a déjà été mise à jour : Flag(A,3)=1. On met à jour la distance totale dans la mémoire destination : Distance totale (A,3)) = 1
10. On met à jour la séquence des bits décodés de la mémoire destination avec la valeur correspondante: Symboles(A,3)=Symboles(B,2) décalé à gauche +k.

Comme il s'agit du deuxième symbole reçu et que l'état initial du décodeur était 0 (par hypothèse) on ne traite pas les 2 autres lignes qui ne sont pas des hypothèses valides.

« Fin de traitement du 2è symbole 00 » (figure 9c).

1. On normalise les distances de manière à éviter un débordement : on retire à toutes les distances de la mémoire destination la valeur de la distance la plus faible (1).

2. On inverse le rôle des mémoires source et destination.

3. On remet à 0 tous les flags.

On considère alors le traitement du troisième symbole reçu soit la paire 11. Dans ce cadre-là on traite successivement les quatre lignes.

« Réception du 3è symbole 11 ; traitement de la ligne 0 » : (figure 10a):

1. On calcule la distance totale correspondant à l'adresse 1 de la ligne 0 de la mémoire source:
2. Distance totale (B,adresse1 (A,0)) = Distance totale (A,0) + abs{symbole reçu-metrique1 (A,0)}
Soit: Distance totale (B,0)) = 1 + abs({ 1;1}-{0;0}) =3
3. On vérifie la valeur du flag à l'adresse de la mémoire de destination pour s'assurer qu'elle n'a pas déjà été écrite durant ce cycle
Flag(B,0)=0 : pas encore écrite:
4. On change la valeur du flag pour dire que l'adresse a déjà été mise à jour : Flag(B,0)=1. On met à jour la distance totale dans la mémoire destination : Distance totale (B,0)) =3.
5. On met à jour la séquence des bits décodés de la mémoire destination avec la valeur correspondante: Symboles(B,0)=Symboles(A,0) décalé à gauche +k.
6. On calcule la distance totale correspondant à l'adresse 2 de la ligne 0 de la mémoire source:
7. Distance totale (B,adresse2(A,0)) = Distance totale (A,0) + abs{symbole reçu-metrique2(A,0)}
Soit: Distance totale (B,2)) = 1 + abs({ 1;1}-{1;1}) = 1
8. On vérifie la valeur du flag à l'adresse de la mémoire de destination pour s'assurer qu'elle n'a pas déjà été écrite durant ce cycle
Flag(B,0)=0 : pas encore écrite:
9. On change la valeur du flag pour dire que l'adresse a déjà été mise à jour : Flag(B,0)=1. On met à jour la distance totale dans la mémoire destination : Distance totale (B,2)) = 1.
10. On met à jour la séquence des bits décodés de la mémoire destination avec la valeur correspondante: Symboles(B,2)=Symboles(A,0) décalé à gauche +k.

« Réception du 3è symbole 11 ; traitement de la ligne 1 » : (figure 10b) :

1. On calcule la distance totale correspondant à l'adresse 1 de la ligne 1 de la mémoire source:
2. Distance totale (B,adresse1(A,1)) = Distance totale (A,1) + abs{symbole reçu-metrique1 (A,1)}
Soit: Distance totale (B,0)) = 0+ abs({ 1;1}-{1;1}) =0
3. On vérifie la valeur du flag à l'adresse de la mémoire de destination pour s'assurer qu'elle n'a pas déjà été écrite durant ce cycle
Flag(B,0)=1 : déjà écrite. La distance calculée (0) est inférieure à la distance stockée (3) donc on met à jour cette dernière :

Distance totale (B,0)) = 0.

4. On met à jour la séquence des bits décodés de la mémoire destination avec la valeur correspondante: Symboles(B,0)=Symboles(A,1) décalé à gauche +k.
5. On calcule la distance totale correspondant à l'adresse 2 de la ligne 1 de la mémoire source:
6. Distance totale (B,adresse2(A,1)) = Distance totale (A,1) + abs{symbole reçu-metrique2(A,1)}
Soit: Distance totale (B,2)) = 0 + abs({ 1;1}-{0;0}) =2
7. On vérifie la valeur du flag à l'adresse de la mémoire de destination pour s'assurer qu'elle n'a pas déjà été écrite durant ce cycle
Flag(B,2)=1 : déjà écrite : La distance calculée (2) est supérieure à la distance stockée (1) donc on ne met pas à jour cette dernière.

- On ne met pas à jour la séquence des bits décodés de la mémoire destination.

« Réception du 3è symbole 11 ; traitement de la ligne 2 » : (figure 10c) :

1. On calcule la distance totale correspondant à l'adresse 1 de la ligne 2 de la mémoire source:
2. Distance totale (B,adresse1(A,2)) = Distance totale (A,2) + abs{symbole reçu-metrique1 (A,2)}
Soit: Distance totale (B,1)) = 3+ abs({ 1;1}-{1;0}) =4
3. On vérifie la valeur du flag à l'adresse de la mémoire de destination pour s'assurer qu'elle n'a pas déjà été écrite durant ce cycle
Flag(B,1)=0 : pas encore écrite:
4. On change la valeur du flag pour dire que l'adresse a déjà été mise à jour : Flag(B,1)=1. On met à jour la distance totale dans la mémoire destination : Distance totale (B,1)) =4.
5. On met à jour la séquence des bits décodés de la mémoire destination avec la valeur correspondante: Symboles(B,1)=Symboles(A,2) décalé à gauche +k.
6. On met à jour la distance totale correspondant à l'adresse 2 de la ligne 2 de la mémoire source:
7. Distance totale (B,adresse2(A,2)) = Distance totale (A,2) + abs{symbole reçu-metrique2(A,2)}
Soit: Distance totale (B,3)) = 3 + abs({ 1:1}-{0;1}) =4
8. On vérifie la valeur du flag à l'adresse de la mémoire de destination pour s'assurer qu'elle n'a pas déjà été écrite durant ce cycle
Flag(B,3)=0 : pas encore écrite.
9. On change la valeur du flag pour dire que l'adresse a déjà été mise à jour : Flag(B,3)=1. On met à jour la distance totale dans la mémoire destination : Distance totale (B,3)) =4.
10. On met à jour la séquence des bits décodés de la mémoire destination avec la valeur correspondante: Symboles(B,3)=Symboles(A,2) décalé à gauche +k.

« Réception du 3è symbole 11 ; traitement de la ligne 3 » : (figure 10d) :

1. On calcule la distance totale correspondant à l'adresse 1 de la ligne 3 de la mémoire source:
2. Distance totale (B,adresse1(A,3)) = Distance totale (A,3) + abs{symbole reçu-metrique1 (A,3)}
Soit: Distance totale (B,1)) = 0+ abs({ 1;1}-{0;1}) =1
3. On vérifie la valeur du flag à l'adresse de la mémoire de destination pour s'assurer qu'elle n'a pas déjà été écrite durant ce cycle
Flag(B,1)=1 : déjà écrite. La distance calculée (1) est inférieure à la distance stockée (4) donc on met à jour cette dernière:

Distance totale (B,1)) = 1.

4. On met à jour la séquence des bits décodés de la mémoire destination avec la valeur correspondante: Symboles(B,1)=Symboles(A,3) décalé à gauche +k.
6. On calcule la distance totale correspondant à l'adresse 2 de la ligne 3 de la mémoire source:
7. Distance totale (B,adresse2(A,3)) = Distance totale (A,3) + abs{symbole reçu-metrique2(A,3)}
Soit: Distance totale (B,3)) = 0 + abs({ 1;1}-{1;0}) =1
8. On vérifie la valeur du flag à l'adresse de la mémoire de destination pour s'assurer qu'elle n'a pas déjà été écrite durant ce cycle.
Flag(B,3)=1 déjà écrite. La distance calculée (1) est inférieure à la distance stockée (4) donc on met à jour cette dernière:

Distance totale (B,3)) = 1.

9. On met à jour la séquence des bits décodés de la mémoire destination avec la valeur correspondante: Symboles(B,3)=Symboles(A,3) décalé à gauche +k.

« Fin du traitement du 3è symbole 11 » (figure 10e):

1. Ayant atteint la profondeur de traceback (3 bits) on sort vers la mémoire de bits décodés, le bit correspondant à la ligne de la mémoire de destination ayant la distance totale la plus faible ; ici il s'agit de la ligne 0 (distance 1) et le bit le plus vieux (1). Il correspond au premier bit effectivement émis par l'émetteur.
2. On normalise les distances de manière à éviter un débordement : on retire à toutes les distances de la mémoire destination la valeur de la distance la plus faible (ici 0).
3. On inverse le rôle des mémoires source et destination.
4. On remet à 0 tous les flags.

On considère alors le traitement du quatrième symbole reçu soit la paire 11. Dans ce cadre-là on traite successivement les quatre lignes.

« Réception du 4è symbole 11 ; traitement de la ligne 0 » : (figure 11a):

1. On calcule la distance totale correspondant à l'adresse 1 de la ligne 0 de la mémoire source:
2. Distance totale (A,adresse1(B,0)) = Distance totale (B,0) + abs{symbole reçu-metrique1 (B,0)}
Soit: Distance totale (A,0)) = 0+ abs({ 1;1}-{0;0}) =2
3. On vérifie la valeur du flag à l'adresse de la mémoire de destination pour s'assurer qu'elle n'a pas déjà été écrite durant ce cycle
Flag(A,0)=0 : pas encore écrite:
4. On change la valeur du flag pour dire que l'adresse a déjà été mise à jour : Flag(A,0)=1. On met à jour la distance totale dans la mémoire destination : Distance totale (A,0)) =2.
5. On met à jour la séquence des bits décodés de la mémoire destination avec la valeur correspondante: Symboles(A,0)=Symboles(B,0) décalé à gauche +k.
6. On calcule la distance totale correspondant à l'adresse 2 de la ligne 0 de la mémoire source:
7. Distance totale (A,adresse2(B,0)) = Distance totale (B,0) + abs{symbole reçu-metrique2(B,0)}
Soit: Distance totale (A,2)) = 0 + abs({ 1;1}-{1;1}) =0
8. On vérifie la valeur du flag à l'adresse de la mémoire de destination pour s'assurer qu'elle n'a pas déjà été écrite durant ce cycle
Flag(A,0)=0 : pas encore écrite:
9. On change la valeur du flag pour dire que l'adresse a déjà été mise à jour : Flag(A,0)=1. On met à jour la distance totale dans la mémoire destination : Distance totale (A,2)) = 0.
10. On met à jour la séquence des bits décodés avec la valeur correspondante: Symboles(A,2)=Symboles(B,0) décalé à gauche +k.

« Réception du 4è symbole 11 ; traitement de la ligne 1 » : (figure 11 b) :

1. On calcule la distance totale correspondant à l'adresse 1 de la ligne 1 de la mémoire source:
2. Distance totale (A,adresse1(B,1)) = Distance totale (B,1) + abs{symbole reçu-metrique1(B,1)}
Soit: Distance totale (A,0)) = 1 + abs({ 1;1}-{1;1}) =1
3. On vérifie la valeur du flag à l'adresse de la mémoire de destination pour s'assurer qu'elle n'a pas déjà été écrite durant ce cycle
Flag(A,0)=1 : déjà écrite. La distance calculée (1) est inférieure à la distance stockée (2) donc on met à jour cette dernière :

Distance totale (A,0)) = 1.

4. On met à jour la séquence des bits décodés de la mémoire destination avec la valeur correspondante: Symboles(A,0)=Symboles(B,1) décalé à gauche +k.
5. On calcule la distance totale correspondant à l'adresse 2 de la ligne 1 de la mémoire source:

6. Distance totale (A,adresse2(B,1)) = Distance totale (B,1) + abs{symbole reçu-metrique2(B,1)}
Soit: Distance totale (A,2)) = 1 + abs({ 1;1}-{0;0}) =3
7. On vérifie la valeur du flag à l'adresse de la mémoire de destination pour s'assurer qu'elle n'a pas déjà été écrite durant ce cycle
Flag(A,2)=1 : déjà écrite : La distance calculée (3) est supérieure à la distance stockée (0) donc on ne met pas à jour cette dernière.

- On ne met pas à jour la séquence des bits décodés de la mémoire destination.

« Réception du 4è symbole 11 ; traitement de la ligne 2 » : (figure 11c) :

1. On calcule la distance totale correspondant à l'adresse 1 de la ligne 2 de la mémoire source:
2. Distance totale (A,adresse1(B,2)) = Distance totale (B,2) + abs{symbole reçu-metrique1 (B,2)}
Soit: Distance totale (A,1)) = 1 + abs({ 1;1}-{1;0}) =2
3. On vérifie la valeur du flag à l'adresse de la mémoire de destination pour s'assurer qu'elle n'a pas déjà été écrite durant ce cycle
Flag(A,1)=0 : pas encore écrite:
4. On change la valeur du flag pour dire que l'adresse a déjà été mise à jour : Flag(A,1)=1. On met à jour la distance totale dans la mémoire destination : Distance totale (A,1)) =2.
5. On met à jour la séquence des bits décodés de la mémoire destination avec la valeur correspondante: Symboles(A,1)=Symboles(B,2) décalé à gauche +k.
6. On calcule la distance totale correspondant à l'adresse 2 de la ligne 2 de la mémoire source:
7. Distance totale (A,adresse2(B,2)) = Distance totale (B,2) + abs{symbole reçu-metrique2(B,2)}
Soit: Distance totale (A,3)) = 1 + abs({ 1;1}-{0;1}) =2
8. On vérifie la valeur du flag à l'adresse de la mémoire de destination pour s'assurer qu'elle n'a pas déjà été écrite durant ce cycle
Flag(A,3)=0 : pas encore écrite
9. On change la valeur du flag pour dire que l'adresse a déjà été mise à jour : Flag(A,3)=1. On met à jour la distance totale dans la mémoire destination : Distance totale (A,3)) =2.
10. On met à jour la séquence des bits décodés de la mémoire destination avec la valeur correspondante: Symboles(A,3)=Symboles(B,2) décalé à gauche +k.

« Réception du 4è symbole 11 ; traitement de la ligne 3 » : (figure 11d) :

1. On calcule la distance totale correspondant à l'adresse 1 de la ligne 3 de la mémoire source:
2. Distance totale (A,adresse1(B,3)) = Distance totale (B,3) + abs{symbole reçu-metrique1 (B,3)}
Soit: Distance totale (A,1)) = 1 + abs({ 1;1}-{0;1}) =2
3. On vérifie la valeur du flag à l'adresse de la mémoire de destination pour s'assurer qu'elle n'a pas déjà été écrite durant ce cycle
Flag(A,1)=1 : déjà écrite. La distance calculée (2) est inférieure (ou égale) à la distance stockée (2) donc on met à jour cette dernière:

Distance totale (A,1)) =2.

4. On met à jour la séquence des bits décodés de la mémoire destination avec la valeur correspondante: Symboles(A,1)=Symboles(B,3) décalé à gauche +k.
6. On calcule la distance totale correspondant à l'adresse 2 de la ligne 3 de la mémoire source:
7. Distance totale (A,adresse2(B,3)) = Distance totale (B,3) + abs{symbole reçu-metrique2(B,3)}
Soit: Distance totale (A,3)) = 1 + abs({ 1;1}-{1;0}) =2
8. On vérifie la valeur du flag à l'adresse de la mémoire de destination pour s'assurer qu'elle n'a pas déjà été écrite durant ce cycle
Flag(A,3)=1 déjà écrite. La distance calculée (2) est inférieure (ou égale) à la distance stockée (2) donc on met à jour cette dernière:

Distance totale (A,3)) =2.

9. On met à jour la séquence des bits décodés avec la valeur correspondante: Symboles(A,3)=Symboles(B,3) décalé à gauche +k.

« Fin de traitement du 4è symbole 11 » :

1. Ayant atteint la profondeur de traceback (3 bits) on sort vers la mémoire de bits décodés, le bit correspondant à la ligne de la mémoire de destination ayant la distance totale la plus faible. Ici il s'agit de la ligne 2 (distance 0) et le bit le plus vieux (0). Il correspond au second bit effectivement émis par l'émetteur. On retrouve dans cette branche la suite des autres bits émis (001).
2. On normalise les distances de manière à éviter un débordement : on retire à toutes les distances la valeur de la distance la plus faible (ici 0)
3. On inverse le rôle des mémoires source et destination.
4. On remet à 0 tous les flags (figure 11 e).

On présente à présent le processus générique de traitement mis en oeuvre par l'opérateur.
Initialisation des mémoires ;
Pour chaque symbole reçu:

Pour chaque ligne (i) de la matrice source:

Pour chacun des deux champs adresse (j=1 ou2)

Calculer la nouvelle distance totale par la formule:

Nouvelle Distance = Distance totale (source,i) + abs{symbole reçu-métriquej(source,i)}
Vérifier la valeur de Flag(destination, adressej(source,i)).
Si cette valeur vaut 0 alors

mettre à jour la distance totale de la ligne de la mémoire destination
Distance totale(destination,adressej(source,1)) = Nouvelle Distance
Changer la valeur du flag pour dire que l'adresse a déjà été mise à jour
Mettre à jour la séquence des bits décodés avec la valeur correspondante:

Symboles(destination, adressej(source,i)) )= (Symboles (source, i ) <<1)+o

Si cette valeur vaut 1 alors

Si Distance totale(destination, adresse1 (source,i)) <= Nouvelle Distance

Ne rien faire

Sinon

mettre à jour la distance totale de la ligne de la mémoire destination
Distance totale(destination, adressej(source,i)) = Nouvelle Distance
Changer la valeur du flag pour dire que l'adresse a déjà été mise à jour
Mettre à jour la séquence des bits décodés avec la valeur correspondante:

Symboles(destination, adressej(source,i)) )= (Symboles(source, i ) <<1)+1

A la fin du traitement d'un symbole:

Mettre à 0 tous les flags
Remettre à l'échelle les distance calculées
Sortir le bit arrivé au bout du traceback correspondant à la ligne avec la plus faible distance
Inverser mémoire source et mémoire destination.

S'il s'agit d'un traitement par blocs, le traitement d'un premier bloc dit bloc d'initialisation dont les symboles sont connus a priori, initialise la mémoire destination 50. Le traitement d'un bloc intermédiaire tient compte des distances calculées lors du traitement du bloc précédent. Le traitement d'un bloc final utilise la présence des « tail » bits (6 zéros en fin de message) pour supprimer certains chemins à la fin du traitement.

La profondeur de traceback peut être paramétrée jusqu'à une limite égale à la longueur S du champ « Séquence décodée » dans la mémoire destination 20.

Cette implémentation originale du décodeur Viterbi adapté aux signaux GNSS permet de limiter les ressources matérielles à deux mémoires 10 et 20 ainsi qu'un opérateur 30.

Cette solution permet l'embarquement de ce type de décodeur sur les récepteurs aéronautiques directement dans l'ASIC ou le FPGA dédié au traitement du signal.

## Revendications

1. Récepteur d'un signal numérique équipé d'un décodeur Viterbi à treillis à N états, et à décision pondérée, le treillis étant établi à partir d'un treillis élémentaire comportant N états de départ et N états d'arrivée, chaque état de départ étant relié à deux états d'arrivées par des arcs étiquetés, le signal reçu comportant une suite de symboles, **caractérisé en ce qu'**il comprend un circuit logique programmable qui comporte :

   - une mémoire source A (10) et une mémoire destination B (20) comprenant chacune N lignes et M+L colonnes respectivement attribuées à M champs fixes de description du treillis, et à L champs variables, les champs fixes comportant au moins deux champs d'adresse de destination, un par état d'arrivée et deux champs d'étiquettes des arcs correspondants, les champs variables comportant au moins un champ de distance cumulée en fonction des étiquettes de la maille élémentaire et des symboles reçus, et un champ de séquence des S derniers bits décodés,
   - un opérateur (30) apte à calculer les champs variables d'une mémoire en fonction des champs fixes de ladite mémoire, des symboles reçus et des champs variables de l'autre mémoire et apte à inverser le rôle des mémoires source (10) et destination (20).

2. Récepteur selon la revendication précédente, **caractérisé en ce que** N étant égal à $2^{lc}$, lc étant la longueur de contrainte du codeur, les adresses de destination sont définies sur lc bits.

3. Récepteur selon l'une des revendications précédentes, **caractérisé en ce que** M=4 et L=2 ou 3.

4. Récepteur selon l'une des revendications précédentes, **caractérisé en ce que** la décision pondérée étant codée sur n bits, les étiquettes sont définies sur n bits.

5. Récepteur selon la revendication précédente, **caractérisé en ce que** la distance cumulée est définie sur m bits avec n<m≤S+n.

6. Récepteur selon l'une des revendications précédentes, **caractérisé en ce que** les champs variables comportent un champ indiquant pour chaque ligne de la mémoire si la distance cumulée a déjà été calculée pour le symbole reçu.

7. Récepteur selon la revendication précédente, **caractérisé en ce que** le champ indicateur est défini sur un bit.

8. Récepteur selon l'une des revendications précédentes, **caractérisé en ce qu'**il s'agit d'un récepteur GNSS.

9. Procédé de réception d'un signal numérique au moyen d'un récepteur selon l'une des revendications précédentes, comportant une étape de décodage qui comprend une étape de traitement de chaque symbole reçu qui comporte pour chaque ligne de la mémoire source (10) les sous-étapes suivantes pour chacune des deux adresses de cette ligne :

   - calcul par l'opérateur (30) de la distance entre le symbole reçu et l'étiquette du champ étiquette associé à cette adresse,
   - calcul par l'opérateur (30) de la distance cumulée de la mémoire destination (20) à cette adresse à partir de ladite distance et de la distance cumulée de ladite ligne de la mémoire source, cette distance cumulée dite dernière distance cumulée étant associée à une séquence décodée,
   - si une distance cumulée dite distance cumulée précédente a déjà été calculée à cette adresse, choix par l'opérateur (30) pour cette adresse de la plus petite distance cumulée entre cette distance cumulée précédente et la dernière distance cumulée, et mise à jour de la séquence décodée par la séquence associée à la distance cumulée choisie.

10. Procédé de réception d'un signal numérique selon la revendication précédente, **caractérisé en ce qu'**à la fin de l'étape de traitement du symbole reçu, le rôle des mémoires source (10) et destination (20) est inversé par l'opérateur (30).

11. Procédé de réception d'un signal numérique selon l'une des revendications 9 à 10, **caractérisé en ce qu'**à la fin de l'étape de traitement du symbole reçu, la distance cumulée de chaque ligne de la mémoire destination est normalisée pour éviter un débordement du champ distance cumulée.

12. Procédé de réception d'un signal numérique selon la revendication précédente, **caractérisé en ce qu'**on soustrait à toutes les distances cumulée la plus petite distance cumulée.

13. Procédé de réception d'un signal numérique selon l'une des revendications 9 à 12 prise en combinaison avec la revendication 6, **caractérisé en ce que** la valeur de l'indicateur du champ indicateur s'inverse lorsque la distance cumulée a déjà été calculée et **en ce qu'**à la fin de l'étape de traitement d'un symbole reçu, cet indicateur est réinitialisé pour chaque ligne de la mémoire.

## Claims

1. A digital signal receiver equipped with a Viterbi decoder with an N-state trellis and weighted decision, the trellis being established on the basis of an elementary trellis comprising N initial states and N arrival states, each initial state being linked to two arrival states by labelled arcs, the received signal comprising a series of symbols, **characterised in that** it comprises a programmable logic circuit that comprises:

   - a source memory A (10) and a destination memory B (20), each comprising N rows and M+L columns respectively assigned to M fixed fields for describing the trellis and to L variable fields, the fixed fields comprising at least two destination address fields, one per arrival state and two label fields for the corresponding arcs, said variable fields comprising at least one distance field cumulated as a function of the labels of the elementary mesh and of the received symbols, and a sequence field of the S last decoded bits,
   - an operator (30) designed to calculate the variable fields of a memory as a function of the fixed fields of said memory, of the received symbols and of the variable fields of the other memory and designed to reverse the role of the source (10) and destination (20) memories.

2. The receiver according to the preceding claim, **char-**

**acterised in that** as N is equal to $2^{lc}$, lc being the constraint length of the encoder, the destination addresses are defined on lc bits.

3. The receiver according to any one of the preceding claims, **characterised in that** M=4 and L=2 or 3.

4. The receiver according to any one of the preceding claims, **characterised in that** if the weighted decision is encoded on n bits, the labels are defined on n bits.

5. The receiver according to the preceding claim, **characterised in that** the cumulated distance is defined on m bits with $n<m\leq S+n$.

6. The receiver according to any one of the preceding claims, **characterised in that** the variable fields comprise a field indicating for each row of the memory whether the cumulated distance has already been calculated for the received symbol.

7. The receiver according to the preceding claim, **characterised in that** the indicator field is defined on one bit.

8. The receiver according to any one of the preceding claims, **characterised in that** the receiver is a GNSS receiver.

9. A method for receiving a digital signal by means of a receiver according to any one of the preceding claims, comprising a decoding step that comprises a step of processing each received symbol that comprising, for each row of the source memory (10), the following sub-steps for each of the two addresses of this row:

   - the calculation by the operator (30) of the distance between the received symbol and the label of the label field associated with this address,
   - the calculation by the operator (30) of the cumulated distance from the destination memory (20) to this address from said distance and of the cumulated distance of said row of the source memory, this cumulated distance, referred to as the last cumulated distance, being associated with a decoded sequence,
   - the selection by the operator (30) for this address, if a cumulated distance, referred to as the preceding cumulated distance, has already been calculated at this address, of the shortest cumulated distance between said preceding cumulated distance and the last cumulated distance, and the updating of the decoded sequence by the sequence associated with the selected cumulated distance.

10. The method for receiving a digital signal according to the preceding claim, **characterised in that** at the end of the step of processing the received symbol the role of the source (10) and destination (20) memories is reversed by the operator (30).

11. The method for receiving a digital signal according to any one of claims 9 to 10, **characterised in that** at the end of the step of processing the received symbol the cumulated distance of each row of the destination memory is normalised to prevent an overflow of the cumulated distance field.

12. The method for receiving a digital signal according to the preceding claim, **characterised in that** the smallest cumulated distance is subtracted from all of the cumulated distances.

13. The method for receiving a digital signal according to any one of claims 9 to 12 in combination with claim 6, **characterised in that** the value of the indicator of the indicator field reverses when the cumulated distance has already been calculated and **in that** at the end of the step of processing a received symbol, this indicator is re-initialised for each row of the memory.

**Patentansprüche**

1. Digitaler Signalempfänger, der mit einem Viterbi-Decoder mit einem Gitter mit N Zuständen und gewichteter Entscheidung ausgestattet ist, wobei das Gitter auf der Basis eines Elementargitters erstellt wird, das N Ausgangszustände und N Ankunftszustände beinhaltet, wobei jeder Ausgangszustand durch etikettierte Bögen mit zwei Ankunftszuständen verknüpft ist, wobei das empfangene Signal eine Folge von Symbolen beinhaltet, **dadurch gekennzeichnet, dass** es eine programmierbare Logikschaltung umfasst, die Folgendes beinhaltet:

   - einen Ursprungsspeicher A (10) und einen Zielspeicher B (20), die jeweils N Reihen und M+L Spalten umfassen, die jeweils M festen Feldern zum Beschreiben des Gitters und L variablen Feldern zugeordnet sind, wobei die festen Felder wenigstens zwei Zieladressfelder, eines pro Ankunftszustand, und zwei Felder mit Etiketten der entsprechenden Bögen beinhalten, wobei die variablen Felder wenigstens ein Distanzfeld beinhalten, das in Abhängigkeit von den Etiketten der Elementarzelle und der empfangenen Symbole summiert wird, und ein Sequenzfeld der S letzten decodierten Bits,
   - einen Operator (30) zum Berechnen der variablen Felder eines Speichers in Abhängigkeit von den festen Feldern des Speichers der empfangenen Symbole und der variablen Felder des anderen Speichers und zum Umkehren der Rolle von Ursprungsspeicher (10) und Zielspeicher (20).

2. Empfänger nach dem vorherigen Anspruch, **dadurch gekennzeichnet, dass**, wenn N gleich $2^{lc}$ ist, wobei lc die Beanspruchungslänge des Codierers ist, die Zieladressen auf lc Bits definiert sind.

3. Empfänger nach einem der vorherigen Ansprüche, **dadurch gekennzeichnet, dass** M=4 und L=2 oder 3 ist.

4. Empfänger nach einem der vorherigen Ansprüche, **dadurch gekennzeichnet, dass**, wenn die gewichtete Entscheidung auf n Bits codiert ist, die Etiketten auf n Bits definiert sind.

5. Empfänger nach dem vorherigen Anspruch, **dadurch gekennzeichnet, dass** die summierte Distanz auf m Bits mit $n<m\leq S+n$ definiert ist.

6. Empfänger nach einem der vorherigen Ansprüche, **dadurch gekennzeichnet, dass** die variablen Felder ein Feld beinhalten, das für jede Reihe des Speichers anzeigt, ob die summierte Distanz bereits für das empfangene Symbol berechnet wurde.

7. Empfänger nach dem vorherigen Anspruch, **dadurch gekennzeichnet, dass** das Indikatorfeld auf einem Bit definiert ist.

8. Empfänger nach einem der vorherigen Ansprüche, **dadurch gekennzeichnet, dass** es sich bei dem Empfänger um einen GNSS-Empfänger handelt.

9. Verfahren zum Empfangen eines digitalen Signals durch einen Empfänger nach einem der vorherigen Ansprüche, das einen Decodierschritt beinhaltet, der einen Schritt des Verarbeitens jedes empfangenen Symbols umfasst, der für jede Reihe des Ursprungsspeichers (10) die folgenden Unterschritte für jede der beiden Adressen dieser Reihe beinhaltet:

- Berechnen, durch den Operator (30), der Distanz zwischen dem empfangenen Symbol und dem Etikett des mit dieser Adresse assoziierten Etikettenfeldes,
- Berechnen, durch den Operator (30), der summierten Distanz vom Zielspeicher (20) zu dieser Adresse von der Distanz, und der summierten Distanz der Reihe des Ursprungsspeichers, wobei diese summierte Distanz, als die letzte summierte Distanz bezeichnet, mit einer decodierten Sequenz assoziiert ist,
- Wählen durch den Operator (30) für diese Adresse, wenn eine summierte Distanz, als die vorherige summierte Distanz bezeichnet, bereits an dieser Adresse berechnet wurde, der kleinsten summierten Distanz zwischen dieser vorherigen summierten Distanz und der letzten summierten Distanz, und Aktualisieren der decodierten Sequenz mit der Sequenz, die mit der gewählten summierten Distanz assoziiert ist.

10. Verfahren zum Empfangen eines digitalen Signals nach dem vorherigen Anspruch, **dadurch gekennzeichnet, dass** am Ende des Schrittes des Verarbeitens des empfangenen Symbols die Rolle des Ursprungsspeichers (10) und des Zielspeichers (20) durch den Operator (30) umgekehrt wird.

11. Verfahren zum Empfangen eines digitalen Signals nach einem der Ansprüche 9 bis 10, **dadurch gekennzeichnet**, das am Ende des Schrittes des Verarbeitens des empfangenen Symbols die summierte Distanz jeder Reihe des Zielspeichers normalisiert wird, um ein Überlaufen des summierten Distanzfeldes zu verhüten.

12. Verfahren zum Empfangen eines digitalen Signals nach dem vorherigen Anspruch, **dadurch gekennzeichnet, dass** die kleinste summierte Distanz von allen summierten Distanzen subtrahiert wird.

13. Verfahren zum Empfangen eines digitalen Signals nach einem der Ansprüche 9 bis 12 in Kombination mit Anspruch 6, **dadurch gekennzeichnet, dass** der Wert des Indikators des Indikatorfeldes umgekehrt wird, wenn die summierte Distanz bereits berechnet wurde, und **dadurch**, dass am Ende des Schrittes des Verarbeitens eines empfangenen Symbols dieser Indikator für jede Reihe des Speichers neuinitialisiert wird.

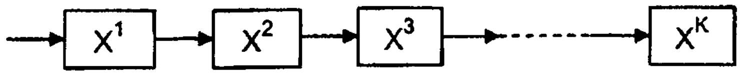


FIG.1

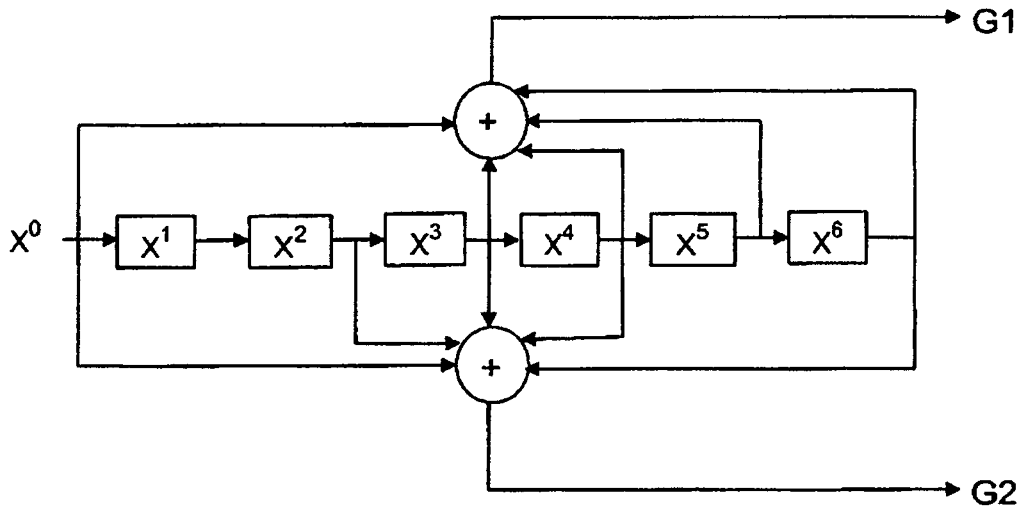


FIG.2

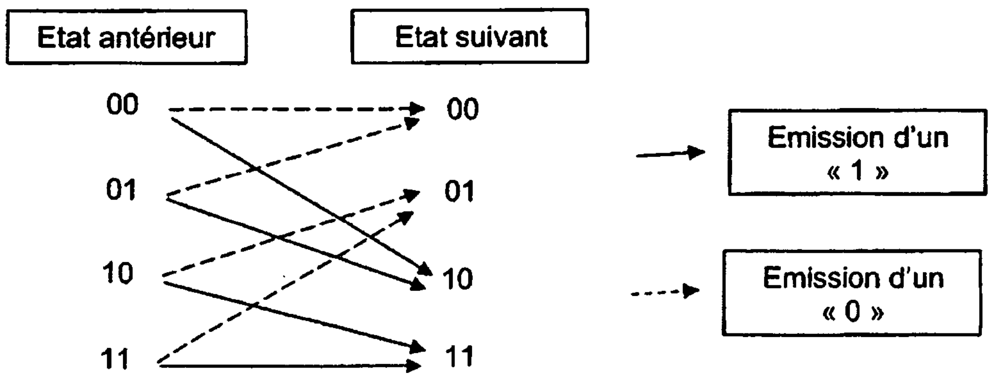


FIG.3

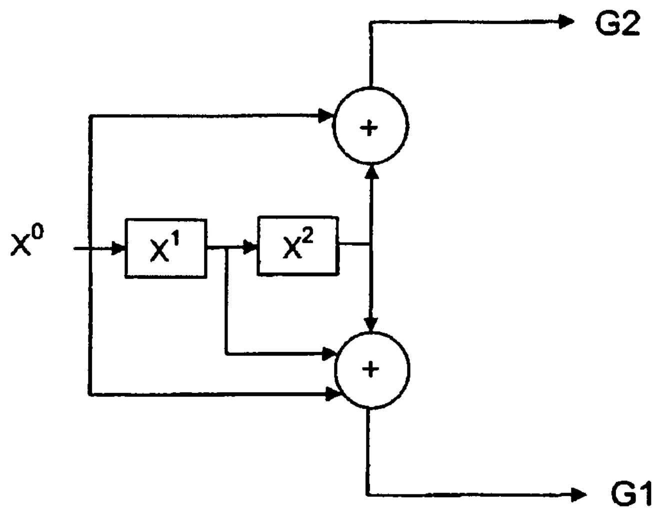
G2
+
$X^0$
$X^1$
$X^2$
+
G1

FIG.4

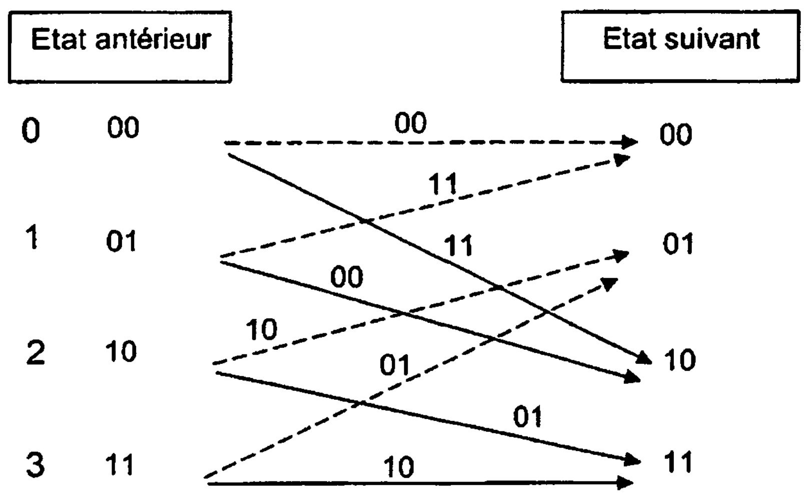
Etat antérieur
Etat suivant
0 00
1 01
2 10
3 11
00
11
11
00
10
01
01
10
00
01
10
11

FIG.5

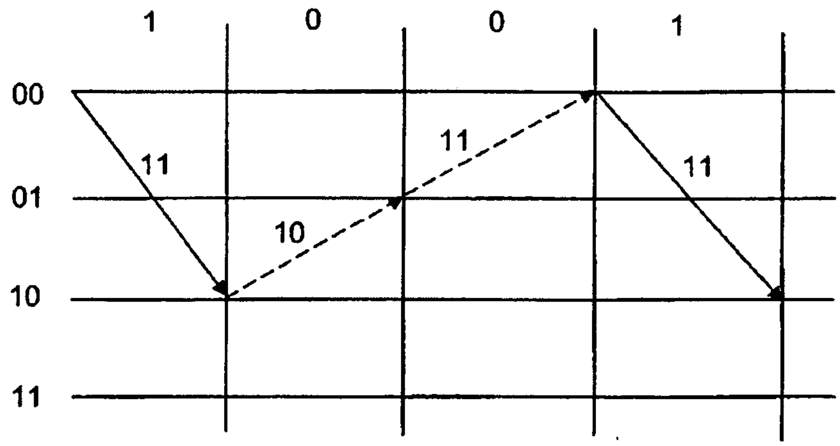
1
0
0
1
00
01
10
11
11
10
11
11

FIG.6

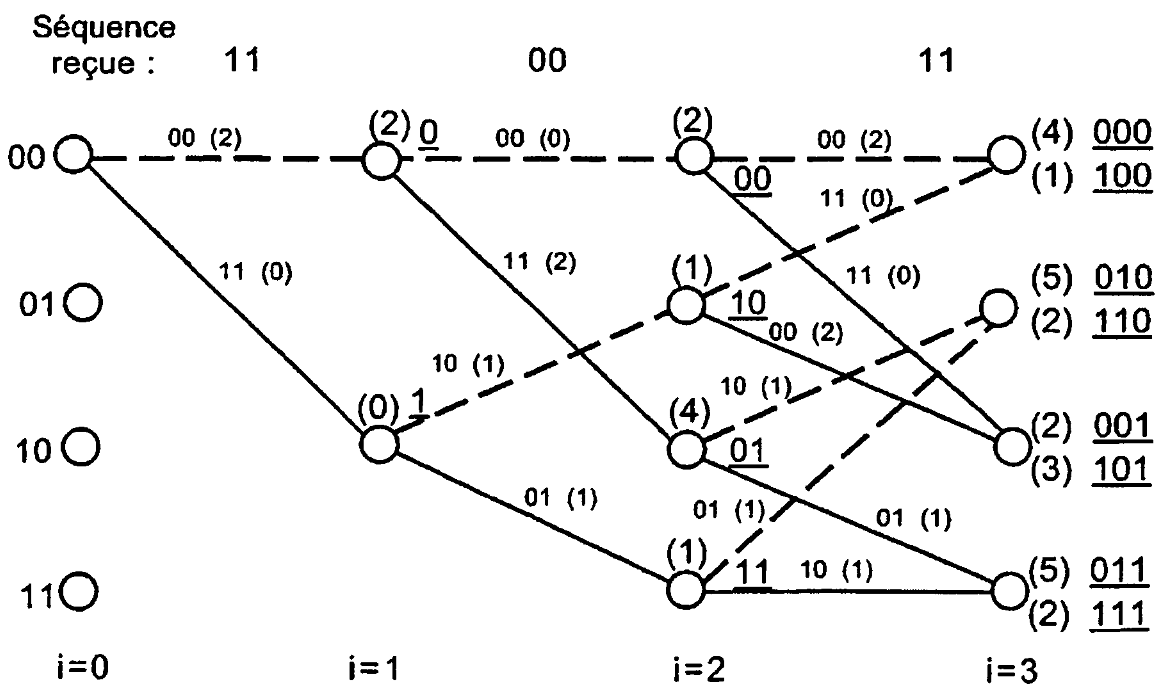
Séquence reçue :
11
00
11
00
01
10
11
i=0
i=1
i=2
i=3
00 (2)
00 (0)
00 (2)
11 (0)
11 (2)
11 (0)
11 (0)
10 (1)
00 (2)
10 (1)
01 (1)
01 (1)
01 (1)
10 (1)
(2) 0
(0) 1
(2)
00
(1)
10
(4)
01
(1)
11
(4) 000
(1) 100
(5) 010
(2) 110
(2) 001
(3) 101
(5) 011
(2) 111

FIG.7a

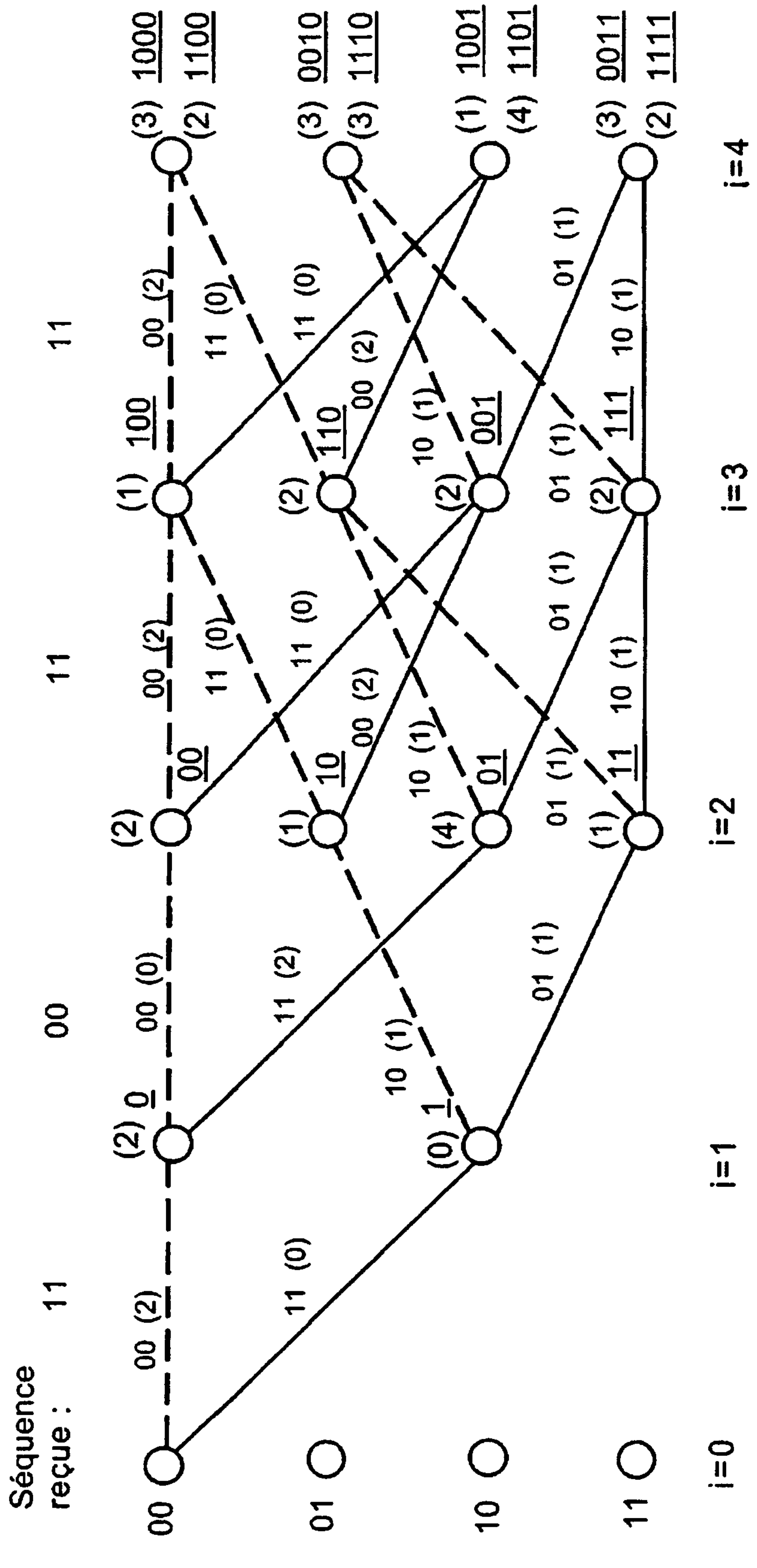
Séquence reçue :
11
00
11
11
00
01
10
11
i=0
i=1
i=2
i=3
i=4
(3) 1000
(2) 1100
(3) 0010
(3) 1110
(1) 1001
(4) 1101
(3) 0011
(2) 1111

FIG.7b

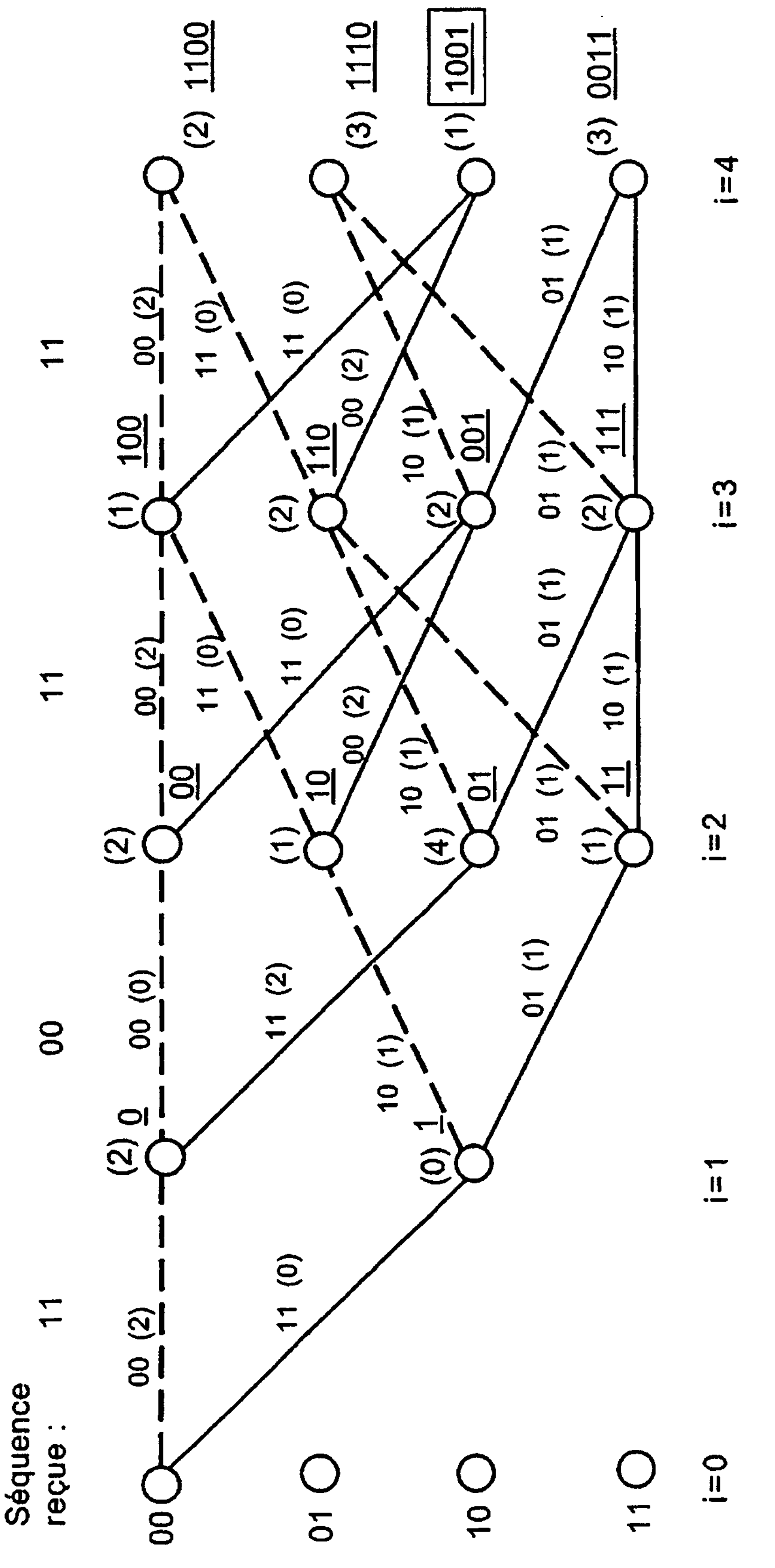
Séquence reçue :
11
00
11
11
00
01
10
11
i=0
i=1
i=2
i=3
i=4
(2) 1100
(3) 1110
(1) 1001
(3) 0011

FIG.7c

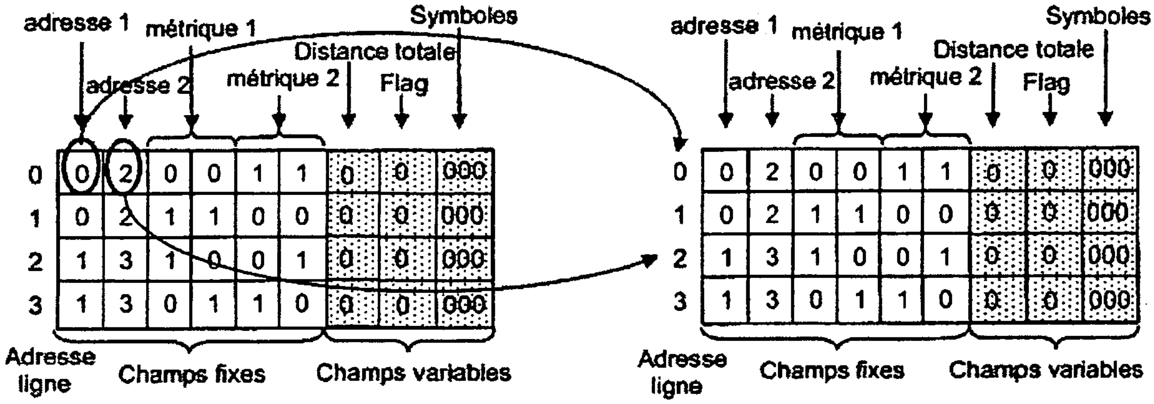


FIG.8a

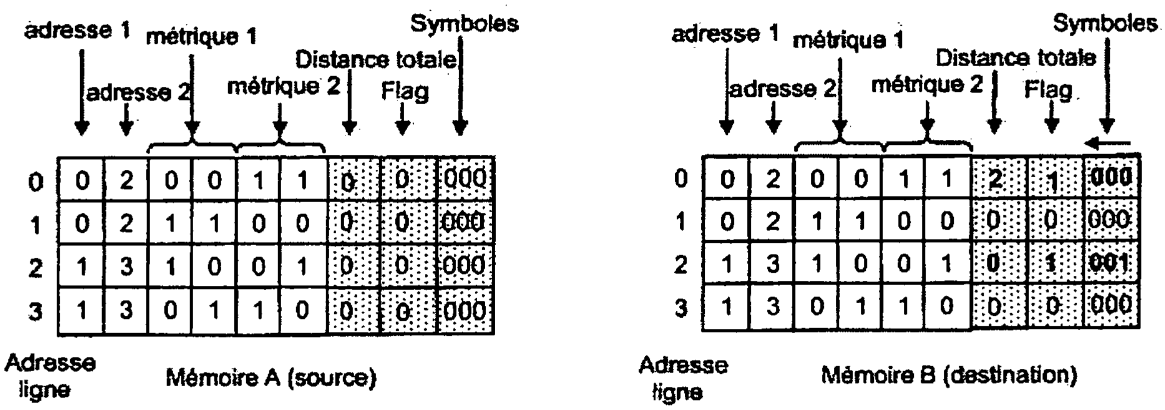


FIG.8b

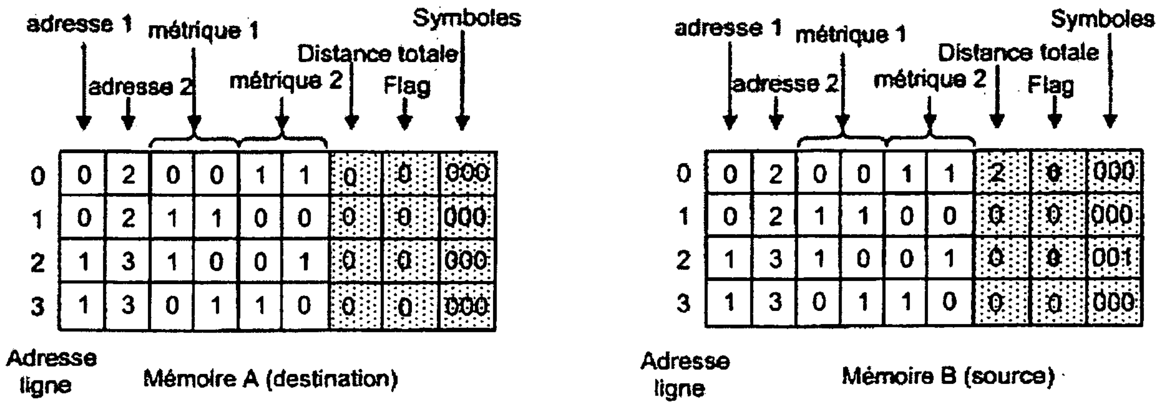


FIG.8c

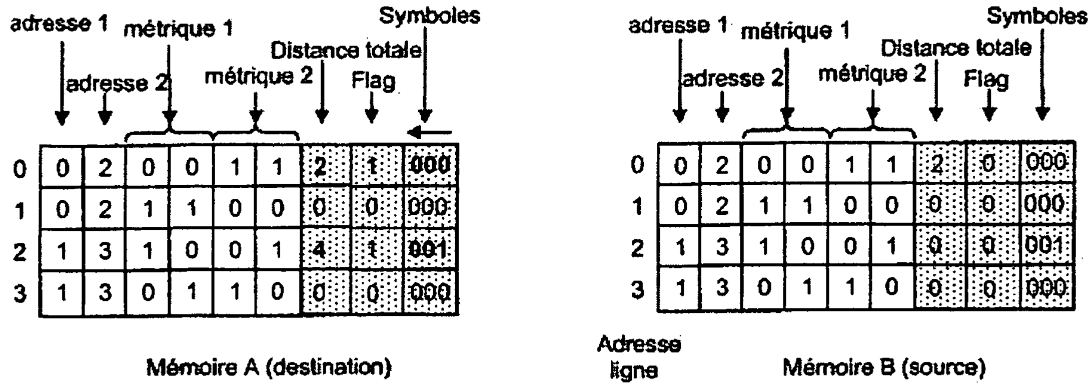


FIG.9a

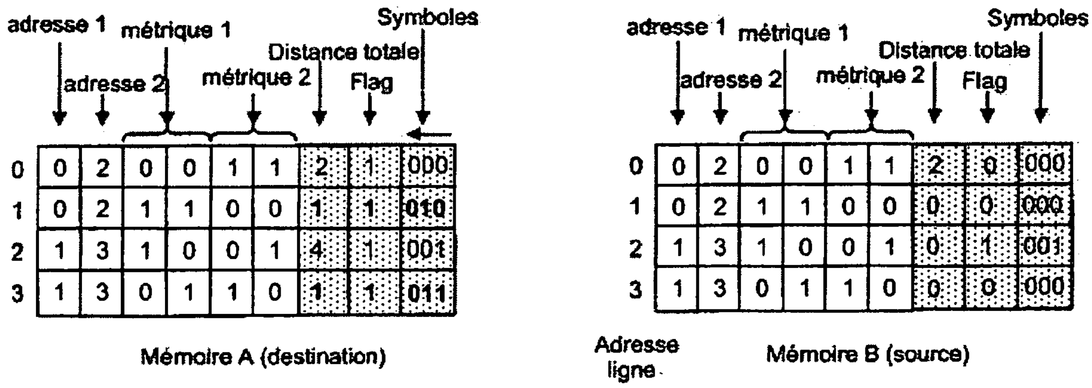


FIG.9b

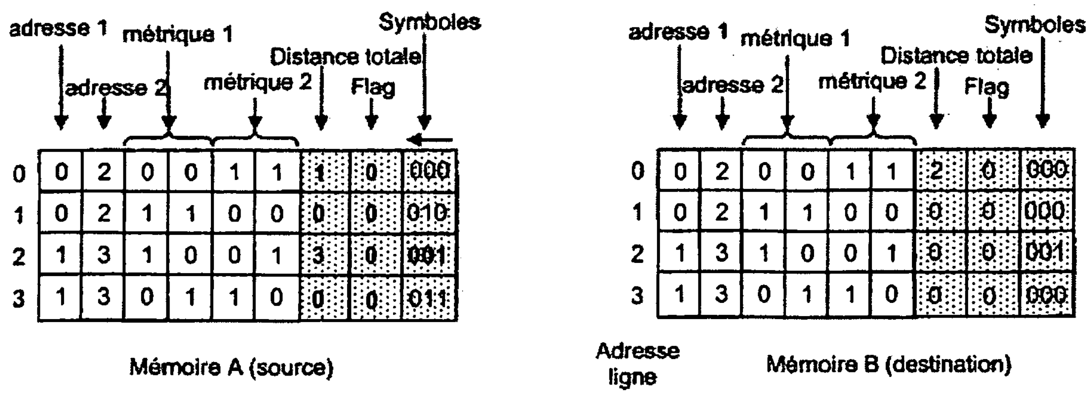


FIG.9c

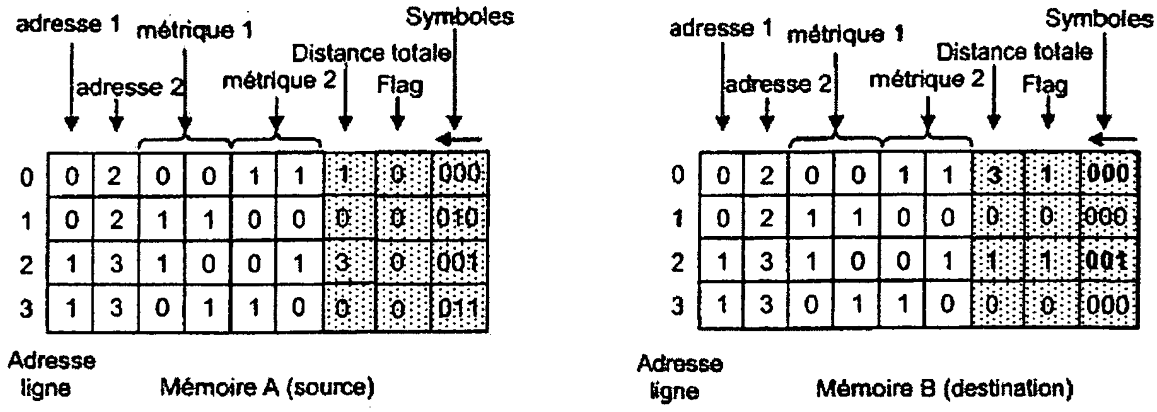


FIG.10a

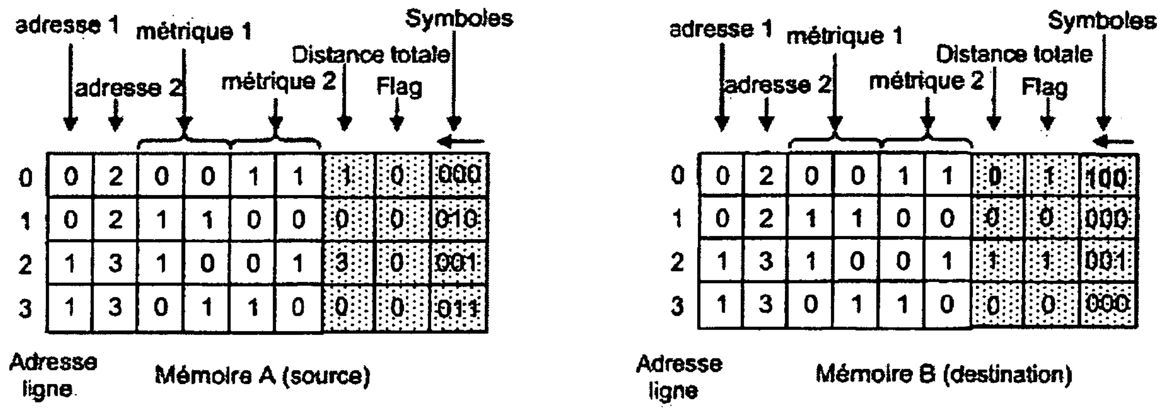


FIG.10b

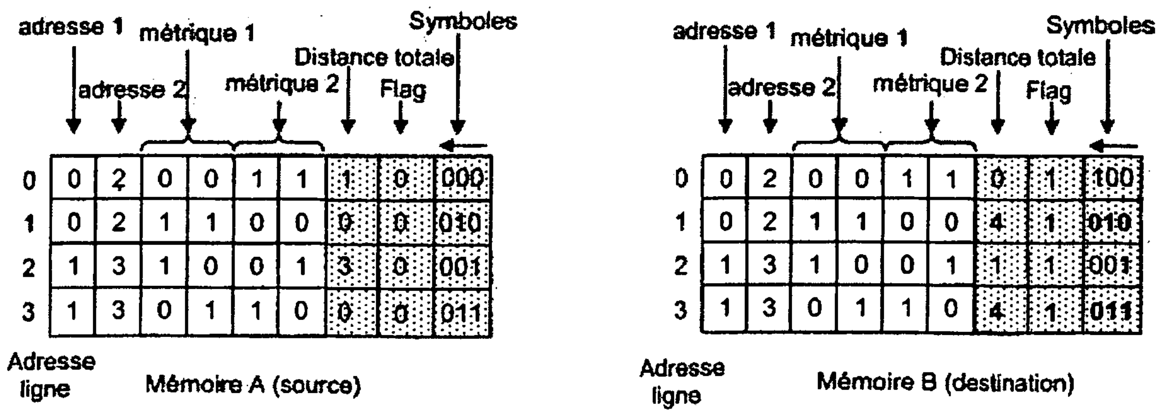


FIG.10c

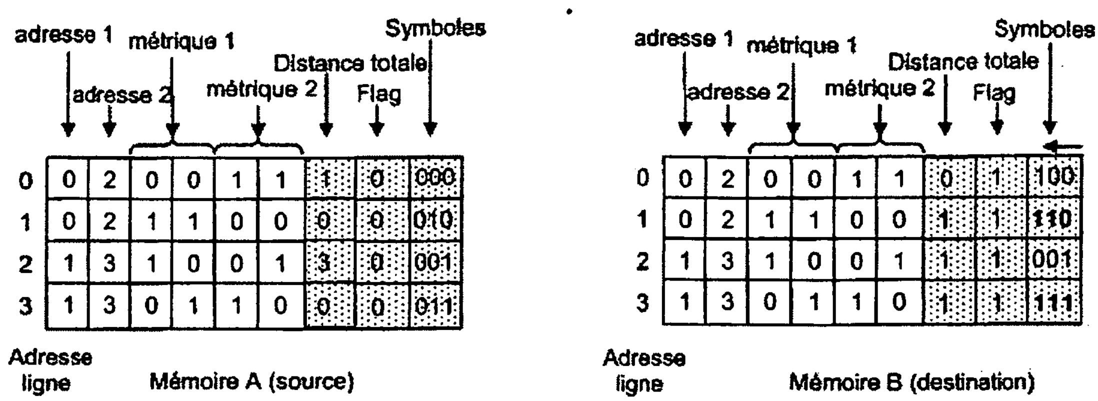


FIG.10d

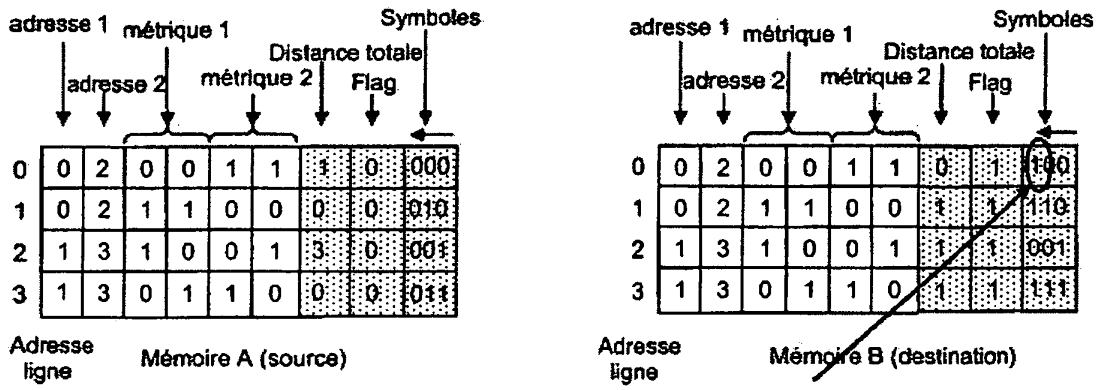


FIG.10e

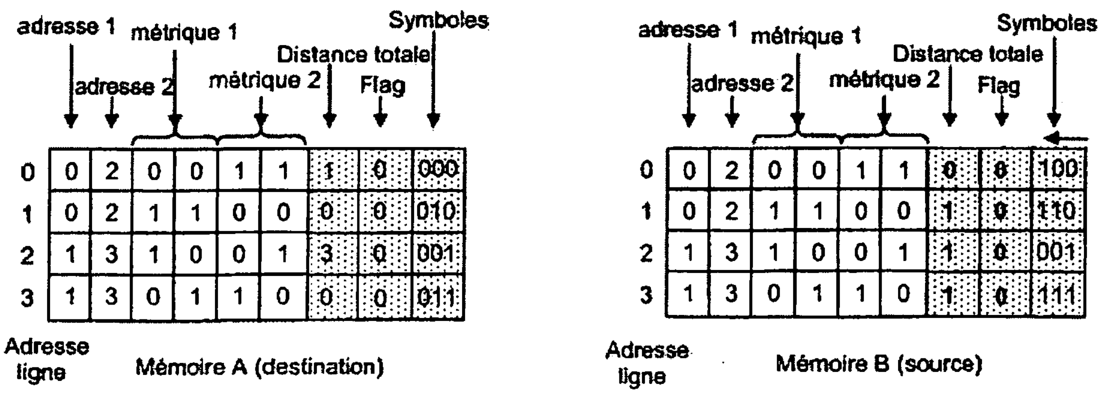


FIG.10f

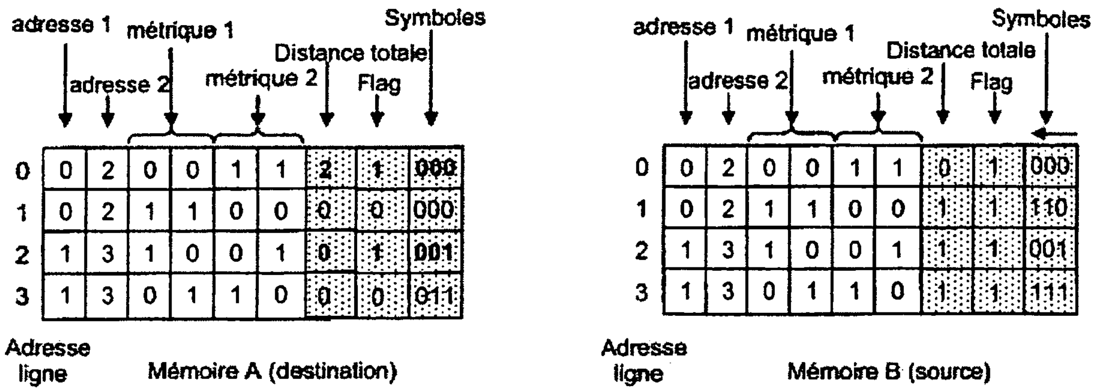


FIG.11a

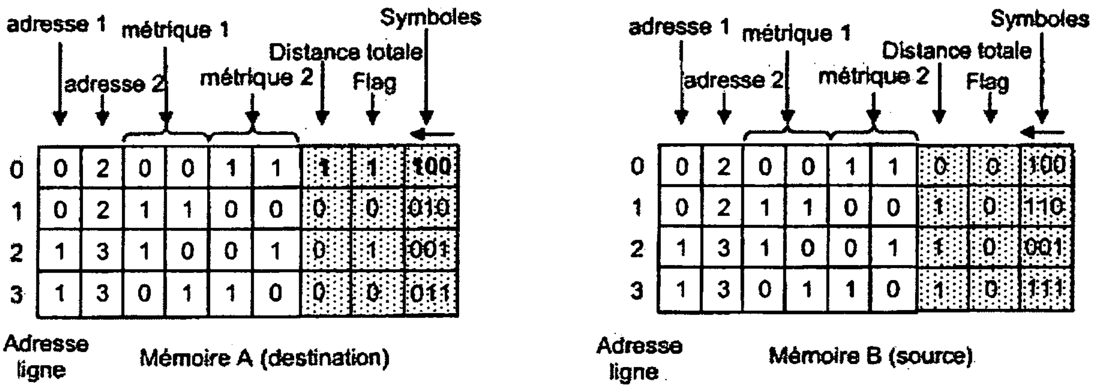


FIG.11b

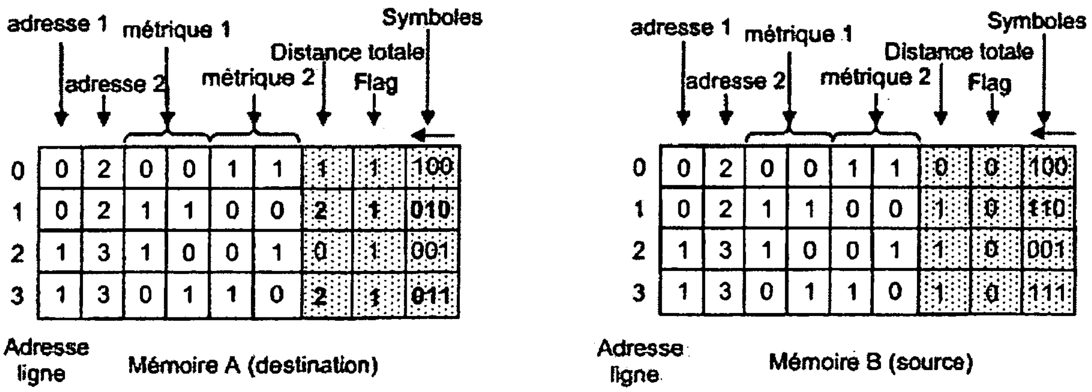


FIG.11c

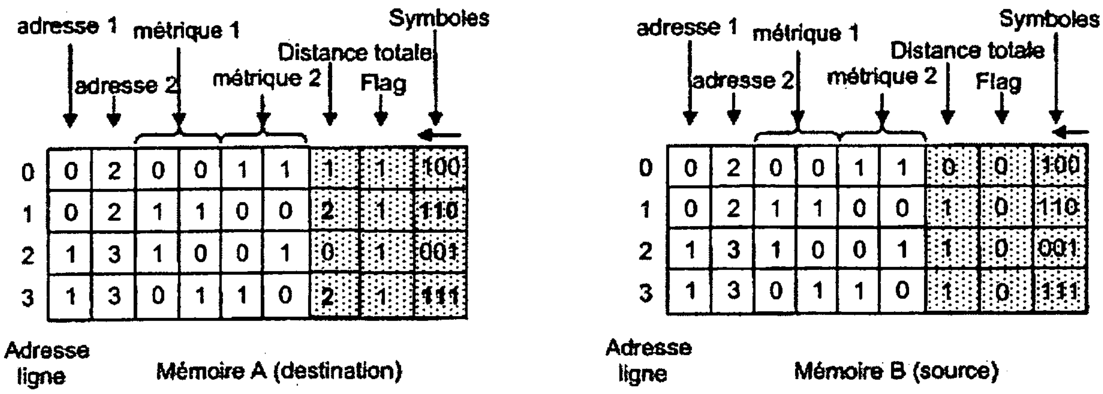


FIG.11d

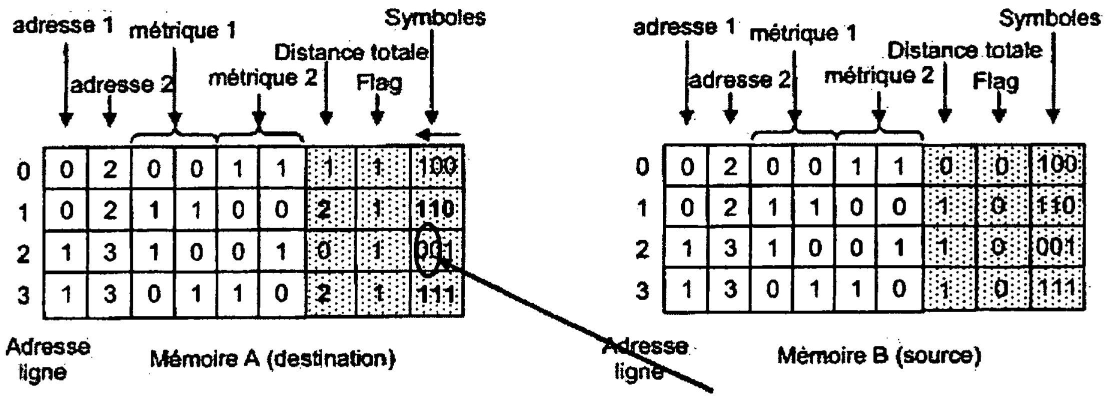


FIG.11e

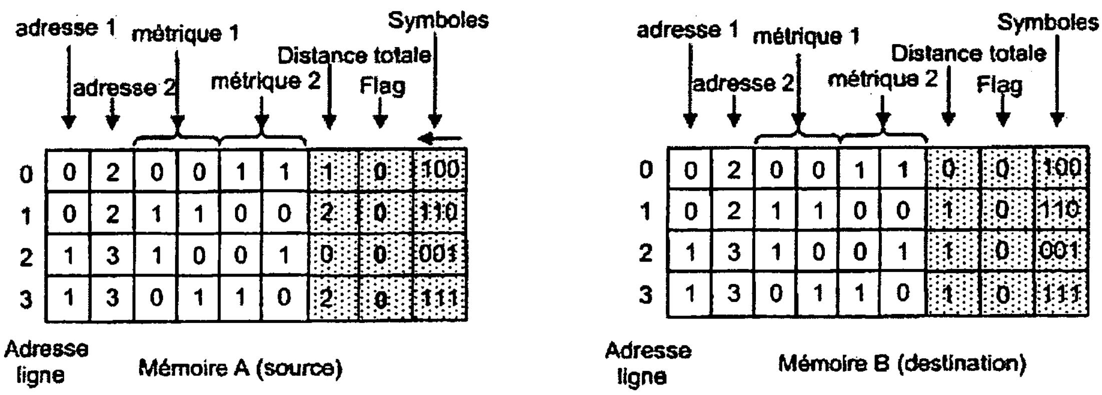


FIG.11f

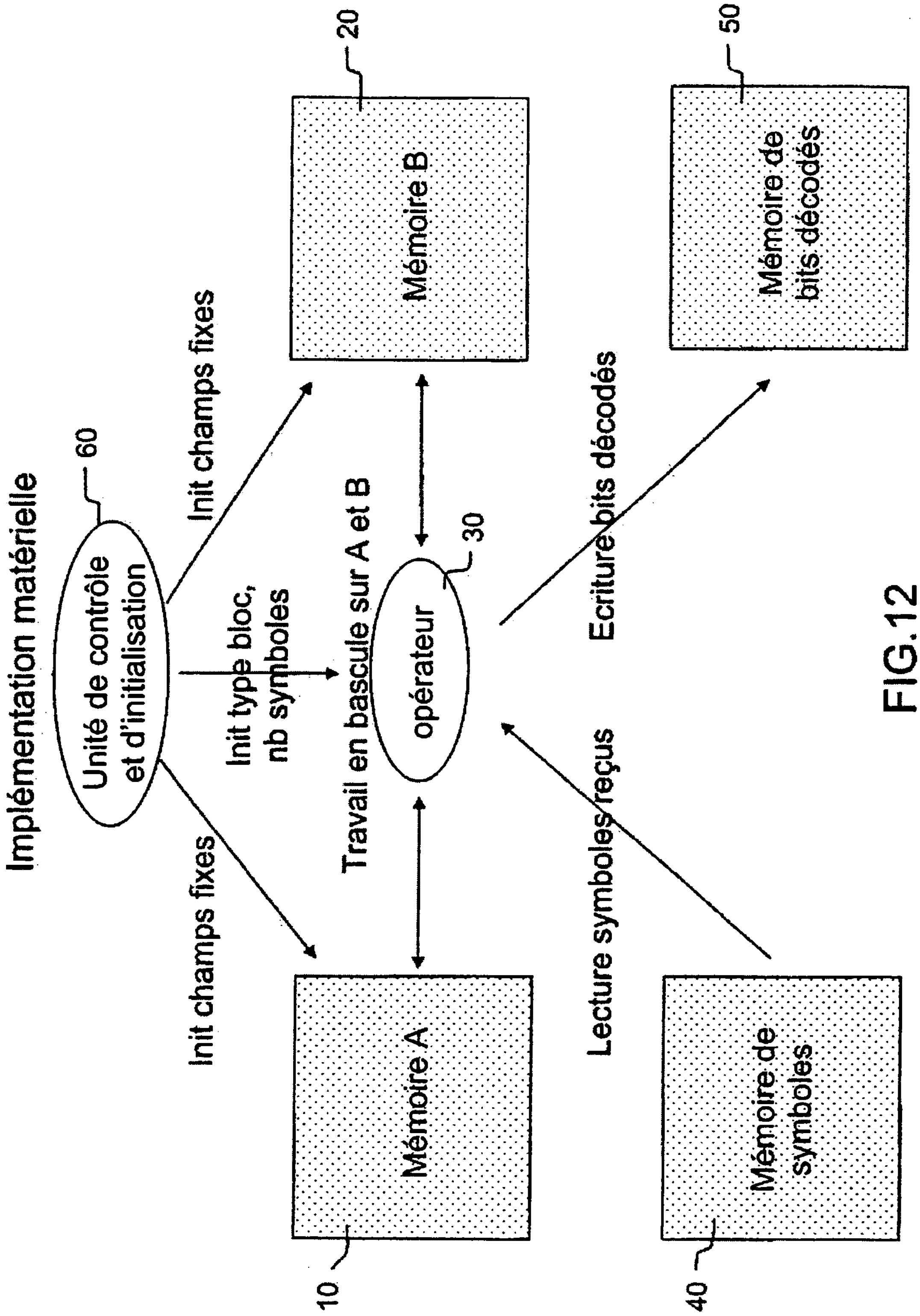
Implémentation matérielle
Unité de contrôle et d'initialisation
60
Init champs fixes
Init champs fixes
Init type bloc, nb symboles
Travail en bascule sur A et B
opérateur
30
Mémoire A
10
Mémoire B
20
Lecture symboles reçus
Ecriture bits décodés
Mémoire de symboles
40
Mémoire de bits décodés
50

FIG.12

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 2006195773 A
- DE 20109857
- US 5887036 A


### Littérature non-brevet citée dans la description


- **Rattan S S et al.** Design of microprocessor based Viterbi decoder. *Students journal of the institution of electronics and telecommunications engineers*